(19) Europäisches Patentamt / European Patent Office / Office européen des brevets

(11) **EP 4 219 653 B1**

(12) **EUROPEAN PATENT SPECIFICATION**

(45) Date of publication and mention
of the grant of the patent:
**19.11.2025 Bulletin 2025/47**

(21) Application number: **23153380.3**

(22) Date of filing: **26.01.2023**

(51) International Patent Classification (IPC):
*C09K 11/02* (2006.01)  *C09K 11/88* (2006.01)
*C09K 11/77* (2006.01)  *C09K 11/08* (2006.01)
*H05B 33/14* (2006.01)

(52) Cooperative Patent Classification (CPC):
**C09K 11/02; C09K 11/0811; C09K 11/7778;
C09K 11/88; H05B 33/14**

(54) **SEMICONDUCTOR NANOPARTICLE, PRODUCTION METHOD THEREOF, AND ELECTROLUMINESCENT DEVICE AND DISPLAY DEVICE INCLUDING THE SAME**

HALBLEITERNANOPARTIKEL, HERSTELLUNGSVERFAHREN DAFÜR UND ELEKTROLUMINESZENZVORRICHTUNG UND ANZEIGEVORRICHTUNG DAMIT

NANOPARTICULE SEMI-CONDUCTRICE, SON PROCÉDÉ DE PRODUCTION, DISPOSITIF ÉLECTROLUMINESCENT ET DISPOSITIF D'AFFICHAGE LA COMPRENANT

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **26.01.2022 KR 20220011835**

(43) Date of publication of application:
**02.08.2023 Bulletin 2023/31**

(73) Proprietor: **Samsung Electronics Co., Ltd.
Gyeonggi-do 16677 (KR)**

(72) Inventors:
• **MIN, Ji Hyun**
  **16677 Suwon-si (KR)**
• **JANG, Eun Joo**
  **16677 Suwon-si (KR)**
• **JANG, Hyo Sook**
  **16677 Suwon-si (KR)**
• **HAN, Yong Seok**
  **16677 Suwon-si (KR)**
• **LEE, Ilyoung**
  **16677 Suwon-si (KR)**
• **CHO, Oul**
  **16677 Suwon-si (KR)**

(74) Representative: **Elkington and Fife LLP
Prospect House
8 Pembroke Road
Sevenoaks, Kent TN13 1XR (GB)**

(56) References cited:
EP-A1- 3 660 124     CN-A- 112 048 300
CN-A- 112 980 428    US-A1- 2020 399 536

Remarks:
The file contains technical information submitted after the application was filed and not included in this specification

**Description**

FIELD OF THE INVENTION

The present disclosure relates to a semiconductor nanoparticle, a production method thereof, and a light emitting device (e.g., an electroluminescent device) and a display device including the same.

BACKGROUND OF THE INVENTION

A semiconductor nanoparticle (e.g., a semiconductor nanocrystal particle) may emit light. For example, a quantum dot including a semiconductor nanocrystal may exhibit a quantum confinement effect. Light emission from the semiconductor nanoparticle may occur when an electron in an excited state resulting from light excitation or an applied voltage transits from a conduction band to a valence band. The semiconductor nanoparticle may be configured to emit light of a desired wavelength region by adjusting a size and/or composition of the semiconductor nanoparticle.

The semiconductor nanoparticle may be used in a light-emitting device (e.g., an electroluminescent device) and a display device including the same.

US 2020/399536 discloses quantum dots, a composition or composite including the quantum dots, and an electronic device (e.g., a display device) including the quantum dots, or the composite including the quantum dots.

CN 112048300 discloses a cadmium-free quantum dot, a preparation method thereof and a quantum dot photoelectric device.

EP 3 660 124 discloses a quantum dot and a quantum dot-polymer composite and a device including the same.

SUMMARY OF THE INVENTION

The invention provides a luminescent device that is configured to emit light, with or without an additional light source, for example, by applying a voltage to a semiconductor nanoparticle such as a quantum dot.

An embodiment provides a display device (e.g., a quantum dot-light-emitting diode (QD-LED) display) that includes the semiconductor nanoparticle in a configuration of a blue pixel, a red pixel and/or a green pixel.

An aspect provides the semiconductor nanoparticle that may be included in the luminescent device of the invention.

An aspect provides a production method of the semiconductor nanoparticle.

Disclosed is a display apparatus including the semiconductor nanoparticle.

The invention provides an electroluminescent device in accordance with claim 1.

The mole ratio of zinc to indium may be greater than or equal to about 67:1.

The light-emitting layer or the semiconductor nanoparticle may not include cadmium.

The first semiconductor nanocrystal may include indium, phosphorus, and optionally zinc. The zinc chalcogenide may include zinc, selenium, and sulfur.

The semiconductor nanoparticle may further include or may not include gallium.

The light emitting layer or the semiconductor nanoparticle may be configured to exhibit an absolute quantum yield of greater than or equal to 90%.

The electroluminescent device may be configured to exhibit a T90 of greater than or equal to 120 hours, as measured with an initial driving luminance of 2700 nit (candelas per square meter, cd/m$^2$). The T90 may be from 120 hours to about 10,000 hours.

The electroluminescent device may be configured to exhibit a T90 of greater than or equal to about 200 hours, or greater than or equal to about 250 hours, for example, as measured with an initial driving luminance of about 2700 nit.

The electroluminescent device may be configured to exhibit a T90 of greater than or equal to 500 hours, as measured with an initial driving luminance of 1000 nit.

The electroluminescent device may be configured to exhibit a T90 of greater than or equal to about 600 hours, for example, as measured with an initial driving luminance of about 2700 nit.

The electroluminescent device may be configured to exhibit a T90 of greater than or equal to about 800 hours, for example, as measured with an initial driving luminance of about 1000 nit.

The semiconductor nanoparticles may have a particle size or an average particle size (hereinafter, a particle size) of greater than or equal to 7.5 nanometers (nm), greater than or equal to about 7.8 nm, greater than or equal to about 8 nm, greater than or equal to about 8.5 nm, or greater than or equal to about 8.7 nm.

The semiconductor nanoparticle may have a particle size of less than or equal to about 50 nm, less than or equal to about 35 nm, less than or equal to about 30 nm, less than or equal to about 14 nm, or less than or equal to about 10 nm.

The zinc chalcogenide may include a first zinc chalcogenide including zinc and selenium; a second zinc chalcogenide including zinc and sulfur; or a combination thereof.

The maximum luminescent peak wavelength may be greater than or equal to about 500 nm and less than or equal to about 550 nm.

The core or the first semiconductor nanocrystal (or the Group III-V compound) may include an indium phosphide optionally further including zinc (e.g., an indium phosphide or an indium zinc phosphide) or a combination thereof. The second semiconductor nanocrystal or the shell may include a first zinc chalcogenide (for example, a zinc selenide) and a second zinc chalcogenide (for example, a zinc sulfide). In an embodiment, the second semiconductor nanocrystal or the shell may include a zinc selenide sulfide.

The shell may be a multi-layered shell. The multi-layered shell may include an inner layer (i.e., a first shell layer) including zinc, selenium, and optionally sulfur and an outer layer (i.e., a second shell layer) disposed on the inner layer, the outer layer including zinc, sulfur, and optionally selenium, and a composition of the inner layer may be different than a composition of the outer layer. The inner layer may be disposed directly on the core. The inner layer may be located between the core and the outer layer.

The inner layer may include a zinc selenide, a zinc selenide sulfide, or a combination thereof. The inner layer may include or may not include sulfur. The outer layer may include a zinc sulfide, a zinc selenide sulfide, or a combination thereof. The shell may have a composition varying in a radial direction.

In the semiconductor nanoparticle or in the light-emitting layer, a mole ratio of zinc to indium may be greater than or equal to about 70:1, or greater than or equal to about 72:1.

In the semiconductor nanoparticle or in the light-emitting layer, a mole ratio of sulfur to indium (S:In) may be greater than or equal to about 11:1, greater than or equal to about 13:1, greater than or equal to about 15:1, greater than or equal to about 17:1, greater than or equal to about 19:1, greater than or equal to about 20:1, greater than or equal to about 21:1, greater than or equal to about 22:1, greater than or equal to about 23:1, greater than or equal to about 24:1, or greater than or equal to about 25:1.

In the semiconductor nanoparticle or in the light-emitting layer, the mole ratio of sulfur to indium (S:In) may be less than or equal to about 40:1, less than or equal to about 35:1, less than or equal to about 30:1, less than or equal to about 25:1, or less than or equal to about 20:1.

In the semiconductor nanoparticle or in the light-emitting layer, a mole ratio of selenium to indium (Se:In) may be greater than or equal to about 25:1, greater than or equal to about 40:1, or greater than or equal to about 50:1.

In the semiconductor nanoparticle or in the light-emitting layer, the mole ratio of selenium to indium (Se:In) may be less than or equal to about 120:1, less than or equal to about 100:1, or less than or equal to about 90:1.

In the semiconductor nanoparticle or in the light-emitting layer, a mole ratio of indium to a sum of selenium and sulfur [In:(S+Se)] may be less than or equal to about 0.05:1, less than or equal to about 0.04:1, less than or equal to 0.03:1, or less than or equal to about 0.02:1.

In the semiconductor nanoparticle or in the light-emitting layer, the mole ratio of indium to a sum of selenium and sulfur [In:(S+Se)] may be greater than or equal to 0.0001:1, greater than or equal to about 0.0005:1, greater than or equal to about 0.001:1, greater than or equal to 0.005:1, or greater than or equal to about 0.01:1.

In the semiconductor nanoparticle or in the light-emitting layer, a mole ratio of zinc to the sum of selenium and sulfur [Zn:(S+Se)] may be less than or equal to about 2:1, less than or equal to about 1.5:1, or less than or equal to about 1.3:1.

In the semiconductor nanoparticles or in the light-emitting layer, the mole ratio of zinc to the sum of selenium and sulfur [Zn:(S+Se)] may be greater than or equal to about 0.7:1, greater than or equal to about 0.9:1, greater than or equal to about 1:1, or greater than or equal to about 1.05:1.

In the semiconductor nanoparticles or in the light-emitting layer, a mole ratio of sulfur to selenium (S:Se) may be less than or equal to about 1:1, less than or equal to about 0.8:1, less than or equal to 0.5:1, less than or equal to about 0.4:1, less than or equal to about 0.3:1, or less than or equal to about 0.25:1.

In the semiconductor nanoparticle or in the light-emitting layer, the mole ratio of sulfur to selenium (S:Se) may be greater than or equal to about 0.15:1.

In the semiconductor nanoparticle or in the light-emitting layer, a mole ratio of sulfur to a sum of selenium and sulfur [S:(Se+S)] may be less than or equal to about 0.31:1, less than or equal to about 0.3:1, less than or equal to about 0.29:1, less than or equal to about 0.28:1, less than or equal to about 0.25:1, or less than or equal to about 0.2:1.

In the semiconductor nanoparticle or in the light-emitting layer, a mole ratio of selenium to a sum of selenium and sulfur [Se:(Se+S)] may be greater than or equal to about 0.69:1, greater than or equal to about 0.7:1, greater than or equal to about 0.71:1, greater than or equal to about 0.72:1, greater than or equal to about 0.75:1, or greater than or equal to about 0.8:1.

A particle size of the semiconductor nanoparticle may be greater than or equal to about 7.8 nm, greater than or equal to 8 nm, or greater than or equal to about 8.5 nm. The semiconductor nanoparticle may exhibit a particle size distribution (e.g., as a standard deviation) that is less than or equal to about 12%, less than or equal to 10%, less than or equal to about 9%, or less than or equal to about 7%, of an average size thereof.

The semiconductor nanoparticle may exhibit an absolute quantum yield of greater than or equal to about 80%, greater than or equal to about 88%, greater than or equal to 90%, greater than or equal to about 93%, or greater than or equal to about 95%.

The semiconductor nanoparticle may exhibit an absolute quantum yield of less than or equal to 100%, less than or equal to about 99%, or less than or equal to about 98%.

The semiconductor nanoparticle may exhibit a full width at half maximum of less than or equal to about 45 nm, less than or equal to about 43 nm, or less than or equal to about 40 nm.

In an ultraviolet-visible (UV-Vis) absorption spectrum of the semiconductor nanoparticle, a valley depth defined by the following equation may be greater than or equal to about 0.3, greater than or equal to 0.35, or greater than or equal to about 0.4:

$$(Abs_{first} - Abs_{valley})/ Abs_{first} = VD$$

wherein $Abs_{first}$ is an absorbance at a wavelength of a first absorption peak, $Abs_{valley}$ is an absorbance at a lowest point of a valley adjacent to the first absorption peak, and VD is the valley depth.

In a UV-Vis absorption spectrum, the semiconductor nanoparticle may exhibit a first absorption peak wavelength that is greater than or equal to about 455 nm or greater than or equal to about 500 nm and less than or equal to about 550 nm, less than or equal to about 530 nm, or less than or equal to about 510 nm.

In the UV-Vis absorption spectrum of the semiconductor nanoparticle, a ratio of an absorbance at a wavelength of 450 nm to the absorbance at the first absorption peak may be greater than or equal to 2:1, greater than or equal to about 2.1:1, or greater than or equal to about 2.2:1.

In a decay associated spectroscopy analysis, the semiconductor nanoparticle may exhibit an emission wavelength difference of less than or equal to about 5 nm, or less than or equal to about 4 nm. The emission wavelength difference may be greater than or equal to about 1 nm.

The electroluminescent device may further include an electron transport layer between the second electrode and the light-emitting layer. The electron transport layer may include zinc oxide nanoparticles. The zinc oxide nanoparticle may have a size or an average size, (hereinafter, "size") of greater than or equal to about 0.5 nm.

The zinc oxide nanoparticles may have a size of less than or equal to about 50 nm. The size of the zinc oxide nanoparticles may be less than or equal to about 20 nm. The size of the zinc oxide nanoparticles may be greater than or equal to about 2 nm and less than or equal to about 10 nm, greater than or equal to about 2.5 nm and less than or equal to about 7 nm, greater than or equal to about 3 nm and less than or equal to about 5 nm, or a combination thereof.

The zinc oxide nanoparticles may further include a first metal. The first metal may include Mg, Ca, Zr, W, Li, Ti, Y, Al, Co, an alkali metal, or a combination thereof.

The electroluminescent device may further include a hole auxiliary layer between the light-emitting layer and the first electrode. The hole auxiliary layer may include a hole transport layer (e.g., including an organic compound), a hole injection layer, or a combination thereof.

The electroluminescent device may exhibit a maximum external quantum efficiency (max EQE) of greater than or equal to 10%, greater than or equal to about 11%, or greater than or equal to about 12%. The electroluminescent device may exhibit a maximum EQE of greater than or equal to about 13%, or greater than or equal to about 15%.

The electroluminescent device may exhibit a maximum luminance of greater than or equal to about 200,000 candelas per square meter (cd/m$^2$), greater than or equal to about 250,000 cd/m$^2$, or greater than or equal to about 280,000 cd/m$^2$.

The electroluminescent device may be configured to exhibit a maximum luminance of greater than or equal to 300,000 cd/m$^2$, greater than or equal to about 310,000 cd/m$^2$, greater than or equal to about 320,000 cd/m$^2$, greater than or equal to about 330,000 cd/m$^2$, greater than or equal to about 340,000 cd/m$^2$, or greater than or equal to about 350,000 cd/m$^2$.

An aspect of the invention is about the semiconductor nanoparticle described herein.

An aspect of the invention provides a semiconductor nanoparticle in accordance with claim 9.

In the semiconductor nanoparticle, a mole ratio of zinc to indium may be greater than or equal to about 67:1 or greater than or equal to about 70:1.

In the semiconductor nanoparticle, a mole ratio of indium to a sum of sulfur and selenium [In:(S+Se)] may be less than or equal to about 0.02:1 and a mole ratio of sulfur to selenium (S:Se) may be less than or equal to 0.5:1.

The semiconductor nanoparticle may not include cadmium, lead, or a combination thereof.

In an aspect of the invention, a method of preparing the semiconductor nanoparticle is provided in accordance with claim 15.

The method may include contacting (e.g., adding) the nanoparticle, the selenium precursor, and the additive with (e.g., to) a reaction medium including the zinc precursor. The reaction medium may further include the organic solvent and the organic ligand.

The method may include reacting the zinc precursor with the selenium precursor (and optionally the sulfur precursor) to form an inner layer (e.g., a first shell layer) and then reacting the zinc precursor with the sulfur precursor (and optionally the selenium precursor) to form an outer layer (e.g., a second shell layer) on the inner layer.

In the reaction, an amount of the zinc precursor is greater than or equal to 60 moles, for example greater than or equal to about 67 moles, greater than or equal to about 70 moles, or greater than or equal to about 100 moles per one mole of indium.

In the reaction, a total amount of the selenium precursor and the sulfur precursor may be greater than or equal to about 50 moles, per one mole of indium.

In the reaction, an amount of the sulfur precursor may be less than or equal to about 0.5 moles, per one mole of the selenium precursor.

In the reaction, an amount of the selenium precursor may be greater than or equal to about 36 moles, per one mole of indium.

The additive may be added prior to an addition of the selenium precursor (e.g., to the reaction medium).

The additive may be added after an addition of the selenium precursor (e.g., to the reaction medium).

The additive may be added together with the selenium precursor (e.g., to the reaction medium).

The alkali metal compound may include a C9 to C36 fatty acid salt (e.g., an alkali metal salt compound or an alkali metal carboxylate compound).

The gallium compound may include a C9 to C36 fatty acid salt (e.g., a gallium salt compound).

An amount of the additive used may be greater than or equal to about 0.1 moles, greater than or equal to about 1 mole, or greater than or equal to about 1.5 moles, per 100 moles of the selenium precursor. The amount of the additive used may be less than or equal to about 28 moles, less than or equal to about 10 moles, or less than or equal to about 5 moles, per 100 moles of the selenium precursor.

The selenium precursor may be added or injected at least two times, for example, in a same or different aliquot(s) each time, respectively, to a reaction medium, optionally together with a zinc precursor.

The sulfur precursor may be added or injected at least two times, for example, in a same or different aliquot(s) each time, respectively, to a reaction medium, optionally together with a zinc precursor.

The method may further include an intermediate separation at least one time during the formation of the second semiconductor nanocrystal. In the intermediate separation, a formed particle may be separated from a reaction medium, for example via a non-solvent precipitation, optionally be washed for example an organic solvent, and then is added again to a reaction medium for the formation of the second semiconductor nanocrystal. The formed particles thus separated intermediately may be washed with an organic solvent. The intermediate separation may be conducted after the formation of the inner layer (e.g., the first shell layer) and prior to the formation of the outer layer (i.e., the second shell layer).

The second semiconductor nanocrystal may include a zinc selenide, a zinc sulfide selenide, a zinc sulfide, or a combination thereof.

In an embodiment, a light emitting device may include a light emitting layer including the semiconductor nanoparticle described herein; and a light source, wherein the light source is configured to provide the light emitting layer with an incident light.

In the light emitting layer, the semiconductor nanoparticle may be dispersed in a matrix (e.g., a polymer matrix including an insulating polymer).

In an embodiment, a display device includes the semiconductor nanoparticle, the electroluminescent device, the light emitting device, or a combination thereof.

The display device may include a portable terminal device, a monitor, a notebook computer, a television, an electric sign board, a camera, or an electronic component.

In an embodiment, the semiconductor nanoparticle may be environmentally friendly and may exhibit improved properties and the electroluminescent device including the same may exhibit improved electroluminescent properties together with improved lifespan. The semiconductor nanoparticle may be used in various display devices and biological labeling (e.g., biosensors or bio-imaging), photodetectors, solar cells, or hybrid composites. In an embodiment, the light-emitting device or the electroluminescent device may contribute to realization of, e.g., providing, improved display quality when being applied to, e.g., used in, a display device.

BRIEF DESCRIPTION OF THE DRAWINGS

The above and other advantages and features of this disclosure will become more apparent by describing in further detail exemplary embodiments thereof with reference to the accompanying drawings, in which:

FIG. 1 is a schematic cross-sectional representation of an embodiment of a light-emitting device.
FIG. 2 is a schematic cross-sectional representation of an embodiment of a light-emitting device.
FIG. 3 is a schematic cross-sectional representation of an embodiment of a light-emitting device.

FIG. 4 is a graph of photoluminescence (PL) intensity (arbitrary units, a.u.) vs. wavelength (nanometers, nm) and shows the results of Decay Associated Spectrum (DAS) analysis of the semiconductor nanoparticle synthesized in Preparation Example 1.

FIG. 5 is a graph of PL intensity (a.u.) vs. wavelength (nm) and shows the results of DAS analysis of the semiconductor nanoparticle synthesized in Comparative Preparation Example 2.

FIG. 6 is an illustration for explaining the concept of valley depth.

FIG. 7A is an exploded view of an embodiment of a display device.

FIG. 7B is a schematic cross-sectional view of an embodiment of a display device.

FIG. 7C is a schematic cross-sectional view of an embodiment of a display device.

## DETAILED DESCRIPTION OF THE EMBODIMENTS

Advantages and characteristics of this disclosure, and a method for achieving the same, will become evident referring to the following example embodiments together with the drawings attached hereto. However, this invention may, be embodied in many different forms, the embodiments should not be construed as being limited to the embodiments set forth herein. Rather, these embodiments are provided so that this disclosure will be thorough and complete, and will fully convey the scope of the invention to those skilled in the art. Like reference numerals refer to like elements throughout.

If not defined otherwise, all terms in the specification (including technical and scientific terms) are used as commonly understood by a person of ordinary skilled in the art. It will be further understood that terms, such as those terms defined in a common dictionary should be interpreted as having a meaning that is consistent with their meaning in the context of the relevant art, and may not be interpreted ideally or exaggeratedly unless clearly defined. The terminology used herein is for the purpose of describing particular embodiments and is not intended to be limiting.

As used herein, the singular forms "a," "an," and "the" are intended to include the plural forms, including "at least one," unless the content clearly indicates otherwise. For example, "an element" has the same meaning as "at least one element," unless the context clearly indicates otherwise. Accordingly, as used herein, the wording "a nanoparticle" may refer to a single nanoparticle or a plurality of nanoparticles. For example, the wording "a semiconductor nanoparticle" may refer to a single semiconductor nanoparticle or a plurality of semiconductor nanoparticles. "At least one" is not to be construed as limiting "a" or "an." "Or" means "and/or." As used herein, the term "and/or" includes any and all combinations of one or more of the associated listed items. It will be further understood that the terms "comprise" and variations such as "comprises," "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. In order to clearly illustrate the embodiments in the drawings, some portions not really relevant to the explanation may be omitted.

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

As used herein, the term "cross-sectional" means a case in which a cross-section of a given object is cut, for example, in a substantially vertical direction and is viewed laterally.

Hereinafter, values of a work function, a conduction band, or a lowest unoccupied molecular orbital (LUMO) (or valence band, or a highest occupied molecular orbital (HOMO)) energy level is expressed as an absolute value from a vacuum level. In addition, when the work function or the energy level is referred to be "deep," "high" or "large," the work function or the energy level has a large absolute value based on "0 electronvolts (eV)" of the vacuum level, while when the work function or the energy level is referred to be "shallow," "low," or "small," the work function or energy level has a small absolute value based on "0 eV" of the vacuum level.

As used herein, the term "Group" may refer to a group of Periodic Table.

As used herein, "Group III" refers to Group IIIA and Group IIIB, and examples of a Group IIIA metal may be Al, In, Ga, or Tl, and examples of Group IIIB may be scandium, or yttrium, but are not limited thereto.

As used herein, "Group V" includes Group VA and includes nitrogen, phosphorus, arsenic, antimony, or bismuth, but is not limited thereto.

As used herein, an average may be mean or median. In an embodiment, the average may be a mean value.

As used herein, when a definition is not otherwise provided, "substituted" refers to replacement of hydrogen of a compound, a group, or moiety by a substituent such as a C1 to C30 alkyl group, a C2 to C30 alkenyl group, a C2 to C30 alkynyl group, a C2 to C30 epoxy group, a C2 to C30 alkylester group, a C3 to C30 alkenylester group (e.g., acrylate group, methacrylate group), a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, - Cl, -Br, or -I), a hydroxy group (-OH), a nitro group ($-NO_2$), a cyano group (-CN), an amino group (-NRR', wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

As used herein, when a definition is not otherwise provided, "hydrocarbon" and "hydrocarbon group" refers to a compound or a group including carbon and hydrogen (e.g., alkyl, alkenyl, alkynyl, or aryl group). The hydrocarbon group may be a group having a monovalence or more formed by removal of a, e.g., one or more, hydrogen atoms from alkane, alkene, alkyne, or arene. In the hydrocarbon or hydrocarbon group, a, e.g., at least one, methylene may be replaced by an oxide moiety, a carbonyl moiety, an ester moiety, -NH-, or a combination thereof. Unless otherwise stated to the contrary, the hydrocarbon compound or hydrocarbon group (alkyl, alkenyl, alkynyl, or aryl) may have 1 to 60, 2 to 32, 3 to 24, or 4 to 12 carbon atoms.

As used herein, when a definition is not otherwise provided, "aliphatic" refers to a saturated or unsaturated linear or branched hydrocarbon or hydrocarbon group. An aliphatic group may be an alkyl, alkenyl, or alkynyl group, for example.

As used herein, when a definition is not otherwise provided, "alkyl" refers to a linear or branched saturated monovalent hydrocarbon group (methyl, ethyl hexyl, etc.).

As used herein, when a definition is not otherwise provided, "alkenyl" refers to a linear or branched monovalent hydrocarbon group having a carbon-carbon double bond.

As used herein, when a definition is not otherwise provided, "alkynyl" refers to a linear or branched monovalent hydrocarbon group having a carbon-carbon triple bond.

As used herein, when a definition is not otherwise provided, "aryl" refers to a group formed by removal of a, e.g., at least one, hydrogen from an arene (e.g., a phenyl or naphthyl group).

As used herein, when a definition is not otherwise provided, "hetero" refers to including 1 to 3 heteroatoms, e.g., N, O, S, Si, P, or a combination thereof.

In an embodiment, "aromatic" or "aromatic group" may include a C6 to C30 aromatic group (e.g., consisting of hydrocarbon) or an aromatic ring including a heteroatom (e.g., a C3 to C30 heteroaryl group).

The term "alicyclic group" refers to not only a saturated or unsaturated C3 to C30 cyclic group consisting of carbon and hydrogen but also a saturated or unsaturated C3 to C30 heterocyclic group that further includes a hetero atom in addition to carbon and hydrogen.

As used herein, when a definition is not otherwise provided, "alkoxy" means an alkyl group linked via an oxygen (i.e., alkyl-O-), such as a methoxy, ethoxy, or sec-butyloxy group.

As used herein, when a definition is not otherwise provided, "amine group" may be represented by -NRR, wherein each R is independently hydrogen, a C1 to C12 alkyl group, a C7 to C20 alkylaryl group, a C7 to C20 arylalkyl group, or a C6 to C18 aryl group.

As used herein, the expression "not including cadmium (or other harmful heavy metal)" may refer to the case in which a concentration of each of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or zero. In an embodiment, substantially no amount of cadmium (or other heavy metal) may be present or, if present, an amount of cadmium (or other heavy metal) may be less than or equal to a detection limit or as an impurity level of a given analysis tool (e.g., an inductively coupled plasma atomic emission spectroscopy).

In an embodiment, numerical ranges stated herein are inclusive of the endpoint of each range. As used herein, the upper and lower endpoints set forth for various numerical values may be independently combined to provide a range.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 10%, $\pm$ 5% of the stated value.

As used herein, a nanoparticle or a nanostructure is a structure having at least one region or characteristic dimension with a nanoscale dimension. In an embodiment, a dimension (or an average dimension) of the nanoparticle is less than or equal to about 500 nanometers (nm), less than or equal to about 300 nm, less than or equal to about 250 nm, less than or equal to about 150 nm, less than or equal to about 100 nm, less than or equal to about 50 nm, or less than or equal to about 30 nm, and may be greater than about 0.1 nm or about 1 nm. In an embodiment, the structure may have any suitable shape.

A nanoparticle (e.g., a semiconductor nanoparticle) may include a nanowire, a nanorod, a nanotube, a branched nanostructure, a nanotetrapod, a nanotripod, a nanobipod, a nanocrystal, a nanodot, or a multi-pod type shape such as at least two pods, and is not limited thereto. The nanoparticle can be, e.g., substantially crystalline, substantially monocrystalline, polycrystalline, (for example, at least partially) amorphous, or a combination thereof.

The semiconductor nanoparticle (e.g., a quantum dot) may exhibit a quantum confinement or exciton confinement effect. The quantum dot is a type of light-emitting nanostructure. As used herein, a shape of the "quantum dot' may not particularly limited. In the present specification, the term "nanoparticle" or "quantum dot" is not limited in shapes thereof unless specifically defined. A semiconductor nanoparticle may have a size smaller than a diameter of Bohr excitation in the bulk crystal of the same material. A semiconductor nanoparticle may emit light of a wavelength corresponding to a bandgap energy thereof by controlling the size of the emission center of the nanocrystals.

As used herein, T50 refers to a time for a luminance (or a photocurrent) of a given device to decrease to 50% of the initial luminance (or the initial photocurrent) when the device is driven at a predetermined initial luminance.

As used herein, T90 refers to a time for a luminance (or a photocurrent) of a given device to decrease to 90% of the initial luminance (or the initial photocurrent) when the device is driven at a predetermined initial luminance.

As used herein, an external quantum efficiency (EQE) refers to a ratio of the number of photons emitted from a light-emitting diode (LED) to the number of electrons passing through the device. EQE may be a criterion of how efficiently the light-emitting diode converts the electrons into emitted photons. In an embodiment, EQE may be determined based on the following equation:

EQE = (Injection efficiency) x (Solid state quantum yield) x (Extraction efficiency) wherein

Injection efficiency is the proportion of electrons passing through the device that are injected into the active region;
Solid state quantum yield is the proportion of all electron-hole recombinations in the active region that are radiative and produce photons; and
Extraction efficiency is the proportion of photons generated in the active region that escape from the device.

Herein, a maximum external quantum efficiency refers to a maximum value of the external quantum efficiency.

Herein, a maximum luminance refers to a maximum value of luminance that the device can achieve.

As used herein, a quantum efficiency is a term used interchangeably with a quantum yield. The quantum efficiency (or quantum yield) may be measured either in solution or in the solid state (in a composite). In an embodiment, the quantum efficiency (or quantum yield) is a ratio of photons emitted to photons absorbed by the nanostructure or population thereof. In an embodiment, the quantum efficiency may be measured by any suitable method. For example, for fluorescence quantum yield or efficiency, there may be two methods: an absolute method and a relative method.

In the absolute method, the quantum efficiency is obtained by detecting fluorescence of all samples through an integrating sphere. In the relative method, the quantum efficiency of an unknown sample is calculated by comparing a fluorescence intensity of a standard dye (standard sample) with a fluorescence intensity of the unknown sample. Coumarin 153, Coumarin 545, Rhodamine 101 inner salt, Anthracene and Rhodamine 6G may be used as standard dyes according to photoluminescence (PL) wavelengths thereof, but the present disclosure is not limited thereto.

A bandgap energy of a semiconductor nanocrystal particle may be changed according to sizes, structures, and compositions of nanocrystals. A semiconductor nanocrystal may be used as a light-emitting material in a variety of fields for example, in a display device, an energy device, or a bio light-emitting device, for example.

A semiconductor nanocrystal particle-based light-emitting device (hereinafter, also referred to as a QD-LED) that emits light by application of a voltage includes a semiconductor nanocrystal particle as a light-emitting material. In a light emitting device including a light source, a semiconductor nanocrystal particle may be used as a wavelength conversion material that can absorb an incident light emitted from the light source and emit light of a different spectrum from the incident light. The emitted light may have a lower luminescent peak wavelength than a wavelength of the incident light.

The QD-LED adopts a different emission principle from that of an organic light-emitting diode (OLED) emitting light by using an organic material as an emission center, may realize, e.g., exhibit, purer colors (for example, red, green, and/or blue) and improved color reproducibility, and accordingly, may be used as a next generation display device. The QD-LED may be produced with a reduced cost by including a solution process, may be based on an inorganic material, and may be expected to realize e.g., exhibit, increased stability, but technology development for improving device properties and life-span characteristics is still desired.

A quantum dot being configured to exhibit luminescent (e.g., electroluminescent or photoluminescent) properties at a practically applicable, e.g., desirable, level may contain harmful heavy metals such as cadmium (Cd), lead, mercury, or a combination thereof. Accordingly, it is desirable to provide a light-emitting device or a display device having a light-emitting layer substantially free of the harmful heavy metal.

An electroluminescent device according to an embodiment is a self-emissive type light-emitting device configured to emit a desired light by applying a voltage, for example, even in the absence of a light (irradiation) source.

In an embodiment, an electroluminescent device includes a first electrode 1, a second electrode 5 (e.g., spaced from one another or facing each other), and a light-emitting layer 3 disposed between the first electrode and the second electrode. In an embodiment, a light emitting device of an embodiment may include a light source and a light emitting layer, wherein the light source is configured to provide the light emitting layer with incident light. The light-emitting layer includes a semiconductor nanoparticle.

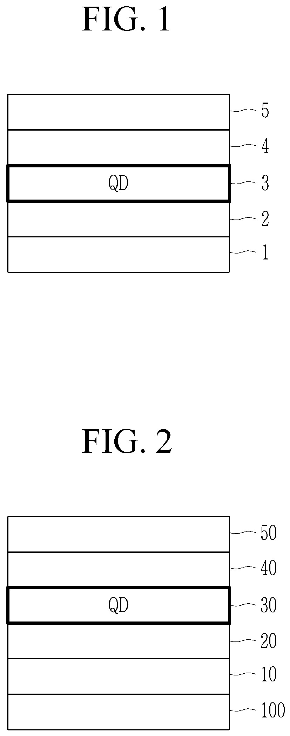

In an embodiment, an electron transport layer 4 may be disposed between the light-emitting layer 3 and the second electrode 5. The electroluminescent device may further include a hole auxiliary layer 2 between the light-emitting layer and the first electrode 1. The hole auxiliary layer may include a hole transport layer (including, for example, an organic compound), a hole injection layer, or a combination thereof. (see FIG. 1)

The semiconductor nanoparticle may not include cadmium. The light-emitting layer (or the electroluminescent device) or the semiconductor nanoparticle is configured to emit green light. The semiconductor nanoparticle includes a semiconductor nanocrystal. The semiconductor nanocrystal includes indium, phosphorus, zinc, selenium, and sulfur. The semiconductor nanocrystal includes a first semiconductor nanocrystal including a Group III-V compound, wherein the Group III-V compound may include indium, phosphorus, and optionally zinc; and a second semiconductor nanocrystal including a zinc chalcogenide, wherein the zinc chalcogenide may include zinc, selenium, and sulfur. The electroluminescent device may exhibit extended electroluminescent lifetime properties. An aspect is also related to the semiconductor nanoparticle described herein or a population thereof.

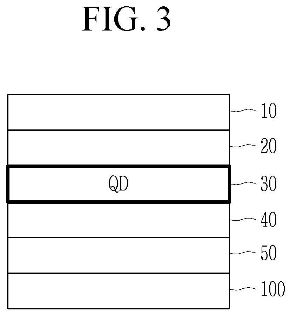

In electroluminescent device of an embodiment, the first electrode 10 or the second electrode 50 may each be disposed on a (transparent) substrate 100. The transparent substrate may be a light extraction surface. Referring to FIGS. 2 and 3, the light-emitting layer 30 may be disposed between the first electrode 10 and the second electrode 50. The second electrode 50 may include an electron injection conductor. The first electrode 10 may include a hole injection conductor. The work functions of the electron/hole injection conductors included in the second electrode and the first electrode may be appropriately adjusted and are not particularly limited. For example, the second electrode may have a small work function and the first electrode may have a relatively large work function, or vice versa.

The electron/hole injection conductors (e.g., second electrode or first electrode) may include a metal-based material (e.g., a metal, a metal compound, an alloy, or a combination thereof) (aluminum, magnesium, tungsten, nickel, cobalt, platinum, palladium, calcium, or LiF), a metal oxide such as gallium indium oxide or indium tin oxide (ITO), or a conductive polymer (e.g., having a relatively high work function) such as polyethylene dioxythiophene, but are not limited thereto.

The first electrode, the second electrode, or a combination thereof, may be a light-transmitting electrode or a transparent electrode. In an embodiment, both the first electrode and the second electrode may be the light-transmitting electrode. The electrode may be patterned. The first electrode, the second electrode, or a combination thereof, may be disposed on a (e.g., insulating) substrate 100. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and for example, less than or equal to about 99%, or less than or equal to about 95%). The substrate may further include a region for a blue pixel, a region for a red pixel, a region for a green pixel, or a combination thereof. A thin film transistor may be disposed in each of the stated regions of the substrate, and one of a source electrode and a drain electrode of the thin film transistor may be electrically connected to the first electrode or the second electrode.

The light-transmitting electrode may be disposed on a (e.g., insulating) transparent substrate. The substrate may be rigid or flexible substrate. Accordingly, the substrate may be plastic, glass, or a metal.

The light-transmitting electrode may include, for example, a transparent conductor such as indium tin oxide (ITO) or indium zinc oxide (IZO), gallium indium tin oxide, zinc indium tin oxide, titanium nitride, polyaniline, or LiF/Mg:Ag, or a thin metal thin film of a single layer or a plurality of layers, but is not limited thereto. When one of the first electrode and the second is an opaque electrode, the opaque electrode may be made of an opaque conductor such as aluminum (Al), a lithium-aluminum (Li:Al) alloy, a magnesium-silver alloy (Mg:Ag), or lithium fluoride-aluminum (LiF:Al).

A thickness of each electrode (e.g., the first electrode, or the second electrode) is not particularly limited and may be appropriately selected taking into consideration device efficiency. For example, the thickness of the electrode may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 micrometers ($\mu$m), less than or equal to about 90 $\mu$m, less than or equal to about 80 $\mu$m, less than or equal to about 70 $\mu$m, less than or equal to about 60 $\mu$m, less than or equal to about 50 $\mu$m, less than or equal to about 40 $\mu$m, less than or equal to about 30 $\mu$m, less than or equal to about 20 $\mu$m, less than or equal to about 10 $\mu$m, less than or equal to about 1 $\mu$m, less than or equal to about 900 nm, less than or equal to about 500 nm, or less than or equal to about 100 nm.

The light-emitting layer 3 or 30 is disposed between the first electrode 1 and the second electrode 5 of FIG. 1 (or e.g., the first electrode 10 and the second electrode 50 of FIGS. 2 and 3). The light-emitting layer includes a semiconductor nanoparticle. The light-emitting layer may include a monolayer of a plurality of semiconductor nanoparticles. The light-emitting layer may include two or more (e.g., three or more) and 10 or less monolayers of the semiconductor nanoparticles.

The light-emitting layer may be patterned. In an embodiment, the patterned light-emitting layer may include a blue light-emitting layer (e.g., disposed within a blue pixel in a display device to be described herein), a red light-emitting layer (e.g., disposed within a red pixel in a display device to be described herein), and a green light-emitting layer (e.g., disposed within a green pixel in a display device to be described herein), or a combination thereof. Each of the light-emitting layers may be (e.g., optically) separated from an adjacent light-emitting layer by a partition wall. In an embodiment, the partition wall such as a black matrix may be disposed between the different color emitting layers, e.g., red light-emitting layer, the green light-emitting layer, and the blue light-emitting layer. In an embodiment, the red light-emitting layer, the green light-emitting layer, and the blue light-emitting layer may each be optically isolated.

The light-emitting layer or the semiconductor nanoparticle may not include cadmium. The light-emitting layer or the semiconductor nanoparticle may not include mercury, lead, or a combination thereof.

The light-emitting layer or the electroluminescent device is configured to emit green light. The green light or the semiconductor nanoparticle has a maximum luminescent peak wavelength of greater than or equal to 490 nm, greater than or equal to about 500 nm, greater than or equal to about 510 nm, greater than or equal to about 515 nm, greater than or equal to about 520 nm, greater than or equal to about 525 nm, greater than or equal to about 530 nm, greater than or equal to about 535 nm, or greater than or equal to about 540 nm. The green light or the semiconductor nanoparticle has a maximum luminescent peak wavelength of less than or equal to 580 nm, less than or equal to about 570 nm, less than or equal to about 565 nm, less than or equal to about 560 nm, less than or equal to about 555 nm, less than or equal to about 550 nm, or less than or equal to about 545 nm.

The green light or the semiconductor nanoparticle may have a maximum luminescent peak having a full width at half maximum of less than or equal to about 45 nm, less than or equal to about 43 nm, less than or equal to about 40 nm, less than or equal to about 35 nm, or less than or equal to about 30 nm and greater than or equal to about 5 nm, greater than or equal to about 10 nm, or greater than or equal to about 15 nm.

The semiconductor nanoparticle (or a population thereof) or a semiconductor nanocrystal included therein includes a first semiconductor nanocrystal including a Group III-V compound and a second semiconductor nanocrystal including a zinc chalcogenide. The Group III-V compound may include indium, phosphorus, and optionally zinc. In an embodiment, the zinc chalcogenide may include zinc, selenium, and sulfur. The semiconductor nanoparticle may be a quantum dot. In an embodiment, the semiconductor nanoparticle or the semiconductor nanocrystal included therein may exhibit a zinc blende crystal structure.

A nanostructure or a semiconductor nanocrystal particle (also referred to as "quantum dot" at times herein) including a Group III-V compound may be a cadmium free semiconductor nanoparticle that may be applied, e.g., used, in a variety of electronic devices such as a display device for example, in a form of a film. The present inventors have found that an indium phosphide-based quantum dot may be desired to have a size of less than about 7 nm for green light emission together with a desired optical property (e.g., a photoluminescent quantum yield).

The present inventors have also found that the indium phosphide-based quantum dot emitting green light may not achieve a desired level of electroluminescent properties. Without wishing to be bound by any theory, it is believed that such a small size desired for green light emission may include a relatively large surface area and a presence of a relatively large amount of an organic ligand thereon. Without wishing to be bound any theory, it is believed that unlike a photoluminescent type device using light as an excitation source, in the electroluminescent device, such a large amount of the organic ligand may play a considerable role of resistance, whereby the properties of the device can be limited and the durability of the device may also be adversely affected.

It may be possible to consider an increase of the size of the light-emitting nanostructure, as a measure of addressing such a drawback. The present inventors have also found that it is very challenging for an indium phosphide-based semiconductor nanoparticle emitting green light to achieve a uniform size growth and that it is also very difficult to realize, e.g., exhibit, a desired level of properties when applied, e.g., used, in an electroluminescent device by using the green light-emitting semiconductor nanoparticle simply having increased sizes. Without wishing to be bound by any theory, it is also believed that for example, in case of the semiconductor nanoparticle having a core-shell structure, a bandgap energy difference between the core and the shell may have a favorable effect on the electroluminescent properties in respect of a quantum confinement effect, but a thickness and a composition of the shell may have a complex effect.

In addition, the present inventors have also found that unlike the InP-based semiconductor nanoparticle emitting red light, in order for the indium phosphide-based semiconductor nanoparticle to emit green light, a first semiconductor nanocrystal included therein is significantly reduced in size, which may increase an effect of an interfacial oxidation between the first semiconductor nanocrystal and the second semiconductor nanocrystal and an effect of a trap energy level generated in the semiconductor nanoparticles.

The present inventors have also found that, as the InP-based semiconductor nanoparticle emitting green light is used for example in an electroluminescent device, a change (e.g., an increase) in a thickness of the second semiconductor nanocrystal may cause a change (e.g., a decrease) in a tunneling current, and this can have an effect on a performance (e.g., a lifespan) of the device, as well.

The present inventors have also found that a bandgap energy difference between the core and the shell may be changed by changing the shell, and some shell capable of imparting a relatively reduced level of the bandgap energy difference may provide a favorable effect on an improvement of a charge flow in the light-emitting layer, but at the same time, may cause a reduced level of a quantum confinement effect for the particle. Therefore, it becomes difficult to achieve a desired level of electroluminescent property (such as an external quantum efficiency) of the device.

In addition, the present inventors have found that in case of a semiconductor nanoparticle having a core-shell structure, an increase of a shell thickness may reduce Fluorescence Resonance Energy Transfer (FRET) or an Auger recombination, contributing to improving the electroluminescent properties of the device, but at the same time, the increased shell thickness may result in the increase of the shell traps, possibly causing a decrease in a luminescent property (e.g., a photoluminescent quantum yield) of the semiconductor nanoparticle.

In addition, the present inventors have found that the decrease of the photoluminescent quantum yield (PLQY) of the semiconductor nanoparticle may vary with the band offset between the core and the shell, and thus, for example, when the band offset between the core and the shell is small, the decrease of the PLQY can be more significant. Without wishing to be bound by any theory, a small band offset may lead to a decrease of the electron confinement, and in this case, an increase of a thickness of the shell may cause a widened electron distribution, and the surface traps of the semiconductor nanoparticle may affect the properties of the particle more significantly and may also affect the electron-hole overlap, resulting in a more sharply decreased PLQY. Without wishing to be bound by any theory, in comparison with the red light-emitting semiconductor nanoparticles, the green light-emitting semiconductor nanoparticle may have a smaller size of the first semiconductor nanocrystal (for example, the core) and a shallower LUMO level, and thus the effects of the shell may become more significant.

The present inventors have also found that in case of the indium phosphide-based semiconductor nanoparticles that are configured to emit green light, not only their sizes but also the second semiconductor nanocrystal (e.g., a content of the shell or the composition and the thickness of the shell) may have an effect on the electroluminescent properties of the semiconductor nanoparticle.

The present inventors have also found that adjusting the aforementioned two factors of the shell in a desired manner may not be possible by a prior art method. For example, providing the first semiconductor nanocrystal designed for the green light emission with the second semiconductor nanocrystal having both of a desired composition and a desired quality (e.g., a desired thickness and a desired shape) would be very difficult in accordance with the prior art method. The present inventors have found that as the second semiconductor nanocrystal of a desired composition grows to reach a certain thickness on the first semiconductor nanocrystal, it becomes more difficult for the second semiconductor nanocrystal to be further formed on the first semiconductor nanocrystal and to have a desired composition of the nanoparticle.

Surprisingly, the present inventors have found that the semiconductor nanoparticle of an embodiment may have the composition recited herein together with a controlled size (and optionally a controlled shape) and thus the electroluminescent device including the semiconductor nanoparticle of the embodiment may exhibit a desired level of an electroluminescent property (such as an external quantum efficiency) and relatively increased lifespan. Accordingly, an electroluminescent device of an embodiment may include the semiconductor nanoparticle having the controlled composition together with a controlled size and optionally a controlled shape in a light-emitting layer.

In an embodiment, the semiconductor nanoparticle is configured to have a band offset between the core and the shell and the thickness of the shell, exhibiting an improved level of luminous property and minimizing the FRET and the Auger recombination. In an embodiment, the semiconductor nanoparticle may include the first semiconductor nanocrystal and the second semiconductor nanocrystal in the manner as described herein, capable of suppressing the unwanted energy transfer and the Auger recombination for example, even with the second semiconductor nanocrystal of the increased thickness, and the electroluminescent device including the semiconductor nanoparticle of the embodiment may exhibit improved electroluminescent properties (such as the maximum luminance and/or the luminous efficiency) together with a significantly improved lifetime of the device. In an embodiment, the semiconductor nanoparticle may emit green light of a desired wavelength and exhibit relatively improved optical properties together with an enhanced stability, and it may be used as a wavelength converting material in a light emitting device including a light source.

The semiconductor nanoparticle of an embodiment may be prepared in the method described herein. According to the method of the embodiment, the semiconductor nanoparticle may have the second semiconductor nanocrystal with the increased amount and the composition described herein formed on the first semiconductor nanocrystal, showing an increased size and optionally a uniform shape (for example, substantially without a significantly grown pod). The device including the semiconductor nanoparticle of the embodiment may provide a relatively significant improvement on the electroluminescent properties.

The semiconductor nanoparticle includes a first semiconductor nanocrystal including a Group III-V compound and a second semiconductor nanocrystal including a zinc chalcogenide. The Group III-V compound may include indium, phosphorus, and optionally zinc. The zinc chalcogenide includes zinc, selenium, and sulfur. The Group III-V compound may be a compound including at least one group III (IUPAC group 13) element and at least one group V element (IUPAC group 15).

In the semiconductor nanoparticle or in the light-emitting layer, a mole ratio of zinc with respect to indium (Zn:In) is greater than or equal to 60:1, for example greater than or equal to about 61:1, greater than or equal to about 62:1, greater than or equal to about 63:1, greater than or equal to about 64:1, greater than or equal to about 65:1, or greater than or equal to about 66:1. In the semiconductor nanoparticle or in the light-emitting layer, a mole ratio of zinc with respect to indium (Zn:In) is greater than or equal to 60:1, for example greater than or equal to about 67:1, greater than or equal to about 68:1, greater than or equal to about 69:1, greater than or equal to about 70:1, greater than or equal to about 71:1, greater than or equal to about 72:1, greater than or equal to about 73:1, greater than or equal to about 74:1, greater than or equal to about 75:1, greater than or equal to about 76:1, greater than or equal to about 77:1, greater than or equal to about 78:1, greater than or equal to about 79:1, or greater than or equal to about 80:1. The mole ratio of zinc to indium is less than or equal to 250:1, for example less than or equal to about 240:1, less than or equal to about 230:1, less than or equal to about 220:1, less than or equal to about 210:1, less than or equal to about 200:1, less than or equal to about 190:1, less than or equal to about 180:1, less than or equal to about 170:1, less than or equal to about 160:1, less than or equal to about 150:1, less than or equal to about 140:1, less than or equal to about 130:1, less than or equal to about 120:1, less than or equal to about 110:1, less than or equal to about 105:1, less than or equal to about 100:1, less than or equal to about 95:1, less than or equal to about 92:1, less than or equal to about 91:1, less than or equal to about 90:1, less than or equal to about 89:1, less than or equal to about 85:1, less than or equal to about 80:1, less than or equal to about 75:1, less than or equal to about 70:1, less than or equal to about 69:1, less than or equal to about 68:1, less than or equal to about 67:1, less than or equal to about 66:1, less than or equal to about 65:1, less than or equal to about 64:1, less than or equal to about 63:1, less than or equal to about 62:1, less than or equal to about 61:1, less than or equal to about 60:1, or less than or equal to about 59:1. The mole ratio of zinc with respect to indium (Zn:In) is from 60:1 to 250:1, for example from about 67:1 to about 230:1, from about 70:1 to about 200:1, from about 75:1 to about 150:1, from about 77:1 to about 130:1, from about 80:1 to about 125:1, from about 90:1 to about 110:1, from about 95:1 to about 107:1, or from about 100:1 to about 105:1.

A mole amount of an element or a mole ratio among elements (for example, included in the semiconductor nanoparticle or the light emitting layer) as described herein may be determined through, e.g., with, an appropriate analysis tool (e.g., an inductively coupled plasma atomic emission spectroscopy (ICP-AES), an X-ray photoelectron spectroscopy (XPS), an ion chromatography, a transmission electron microscopy energy-dispersive X-ray spectroscopy (TEM-EDX), a scanning electron microscopy energy-dispersive X-ray spectroscopy (SEM-EDX), a X-ray fluorescence (XRF), or a combination thereof.

In an embodiment, in the semiconductor nanoparticle or the light-emitting layer, a mole ratio of selenium with respect to indium (Se:In) may be greater than or equal to about 25:1, greater than or equal to about 29:1, greater than or equal to about 30:1, greater than or equal to about 35:1, greater than or equal to about 37:1, greater than or equal to about 38:1, greater than or equal to about 39:1, greater than or equal to about 40:1, greater than or equal to about 41:1, greater than or equal to about 42:1, greater than or equal to about 43:1, greater than or equal to about 44:1, greater than or equal to about 45:1, greater than or equal to about 46:1, greater than or equal to about 47:1, greater than or equal to about 48:1, greater than or equal to about 49:1, greater than or equal to about 50:1, greater than or equal to 51:1, greater than or equal to about 53:1, greater than or equal to about 57:1, greater than or equal to about 59:1, greater than or equal to about 60:1, greater than or equal to about 61:1, greater than or equal to about 63:1, greater than or equal to about 65:1, greater than or equal to about 67:1, greater than or equal to about 69:1, or greater than or equal to about 70:1. The mole ratio of selenium with respect to indium (Se:In) may be less than or equal to about 200:1, less than or equal to about 180:1, less than or equal to about 170:1, less than or equal to about 160:1, less than or equal to about 150:1, less than or equal to about 140:1, less than or equal to about 130:1, less than or equal to about 120:1, less than or equal to about 110:1, less than or equal to about 100:1, less than or equal to about 90:1, less than or equal to about 80:1, less than or equal to about 75:1, less than or equal to about 74:1, less than or equal to about 73:1, less than or equal to about 72:1, less than or equal to about 71:1, less than or equal to about 70:1, less than or equal to about 69:1, less than or equal to about 68:1, less than or equal to about 67:1, less than or equal to about 66:1, less than or equal to about 65:1, less than or equal to about 64:1, less than or equal to about 63:1, less than or equal to about 62:1, less than or equal to about 61:1, less than or equal to about 60:1, less than or equal to about 59:1, less than or equal to about 58:1, less than or equal to about 57:1, less than or equal to about 56:1, less than or equal to about 55:1, less than or equal to about 54:1, less than or equal to about 53:1, or less than or equal to about 52:1.

In an embodiment, in the semiconductor nanoparticle or in the light-emitting layer, a mole ratio of sulfur with respect to indium (S:In) may be greater than or equal to about 11.2:1, greater than or equal to about 11.5:1, greater than or equal to about 12:1, greater than or equal to about 13:1, greater than or equal to about 14:1, greater than or equal to about 15:1, greater than or equal to about 16:1, greater than or equal to about 17:1, greater than or equal to about 18:1, greater than or equal to about 19:1, greater than or equal to about 20:1, greater than or equal to about 21:1, greater than or equal to about 22:1, greater than or equal to about 23:1, greater than or equal to about 24:1, or greater than or equal to about 25:1. The mole ratio of sulfur with respect to indium (S:In) may be less than or equal to about 50:1, less than or equal to about 45:1, less than or equal to about 40:1, less than or equal to about 35:1, less than or equal to about 30:1, less than or equal to about 25:1, less than or equal to about 20:1, less than or equal to about 19:1, less than or equal to about 18:1, less than or equal to about 17:1, less than or equal to about 16:1, less than or equal to about 15:1, or less than or equal to about 14:1.

In an embodiment, in the semiconductor nanoparticle or in the light-emitting layer, a mole ratio of a sum of sulfur and selenium with respect to indium [(S+Se):In] may be greater than or equal to about 50:1, greater than or equal to about 55:1, greater than or equal to about 60:1, greater than or equal to about 61:1, greater than or equal to about 63:1, greater than or equal to about 65:1, greater than or equal to about 67:1, greater than or equal to about 69:1, greater than or equal to about 70:1, greater than or equal to about 71:1, greater than or equal to about 73:1, greater than or equal to about 75:1, greater than or equal to about 77:1, greater than or equal to about 79:1, greater than or equal to about 81:1, greater than or equal to about 83:1, greater than or equal to about 85:1, greater than or equal to about 87:1, greater than or equal to about 89:1, greater than or equal to about 90:1, greater than or equal to about 91:1, greater than or equal to about 93:1, greater than or equal to about 95:1, greater than or equal to about 97:1, greater than or equal to about 99:1, or greater than or equal to about 100:1. In an embodiment, in the semiconductor nanoparticle or in the light-emitting layer, a mole ratio of a sum of sulfur and selenium with respect to indium [(S+Se):In] may be less than or equal to about 250:1, less than or equal to about 230:1, less than or equal to about 210:1, less than or equal to about 200:1, less than or equal to about 190:1, less than or equal to about 180:1, less than or equal to about 170:1, less than or equal to about 160:1, less than or equal to about 150:1, less than or equal to about 140:1, less than or equal to about 130:1, less than or equal to about 120:1, less than or equal to about 110:1, less than or equal to about 100:1, less than or equal to about 90:1, less than or equal to about 85:1, less than or equal to about 80:1, less than or equal to about 75:1, or less than or equal to about 70:1.

In an embodiment, in the semiconductor nanoparticle or in the light-emitting layer, a mole ratio of indium with respect to a total sum of sulfur and selenium [In:(Se+S)] may be less than or equal to about 0.05:1, less than or equal to 0.03:1, less than or equal to about 0.02:1, less than or equal to about 0.015:1, less than or equal to about 0.01:1, less than or equal to about 0.009:1, or less than or equal to about 0.008:1. The mole ratio of indium with respect to a total sum of sulfur and selenium [In:(Se+S)] may be greater than or equal to 0.0005:1, greater than or equal to about 0.001:1, greater than or equal to about 0.003:1, greater than or equal to about 0.005:1, or greater than or equal to about 0.01:1.

In an embodiment, in the semiconductor nanoparticle or the light-emitting layer, a mole ratio of zinc with respect to a total sum of sulfur and selenium [Zn:(Se+S)] may be less than or equal to about 2:1, less than or equal to about 1.9:1, less than or equal to about 1.8:1, less than or equal to about 1.7:1, less than or equal to about 1.6:1, less than or equal to about 1.5:1, less than or equal to about 1.4:1, less than or equal to about 1.3:1, less than or equal to about 1.2:1, less than or equal to about 1.19:1, less than or equal to about 1.18:1, less than or equal to about 1.17:1, less than or equal to about 1.16:1, less than or equal to about 1.15:1, less than or equal to about 1.14:1, less than or equal to about 1.13:1, less than or equal to about 1.12:1, or less than or equal to about 1.1:1. The mole ratio of zinc with respect to a total sum of sulfur and selenium [Zn:(Se+S)] may be greater than or equal to about 0.8:1, greater than or equal to about 0.9:1, greater than or equal to about 1:1, greater than or equal to about 1.05:1, greater than or equal to about 1.1:1, or greater than or equal to about 1.15:1.

In an embodiment, a mole ratio of sulfur with respect to selenium (S:Se) may be less than or equal to 0.5:1, less than or equal to about 0.49:1, less than or equal to about 0.48:1, less than or equal to about 0.47:1, less than or equal to about 0.46:1, less than or equal to about 0.45:1, less than or equal to about 0.44:1, less than or equal to about 0.43:1, less than or equal to about 0.42:1, less than or equal to about 0.41:1, less than or equal to about 0.4:1, less than or equal to about 0.39:1, less than or equal to about 0.38:1, less than or equal to about 0.37:1, less than or equal to about 0.36:1, less than or equal to about 0.35:1, less than or equal to about 0.34:1, less than or equal to about 0.33:1, or less than or equal to about 0.32:1. In an embodiment, a mole ratio of sulfur with respect to selenium (S:Se) may be greater than or equal to about 0.15:1, greater than or equal to about 0.2:1, greater than or equal to about 0.21:1, greater than or equal to about 0.22:1, greater than or equal to about 0.23:1, greater than or equal to about 0.24:1, greater than or equal to about 0.25:1, greater than or equal to about 0.26:1, greater than or equal to about 0.27:1, or greater than or equal to about 0.28:1.

In an embodiment, in the semiconductor nanoparticle or the light-emitting layer, a mole ratio of selenium to a sum of selenium and sulfur [Se:(Se+S)] may be greater than or equal to about 0.69:1, greater than or equal to about 0.7:1, greater than or equal to about 0.71:1, greater than or equal to about 0.72:1, greater than or equal to about 0.73:1, greater than or equal to about 0.74:1, or greater than or equal to about 0.75:1.

In an embodiment, in the semiconductor nanoparticle or the light-emitting layer, a mole ratio of selenium to a sum of selenium and sulfur [Se:(Se+S)] may be less than about 1:1, less than or equal to about 0.99:1, less than or equal to about 0.97:1, less than or equal to about 0.95:1, less than or equal to about 0.93:1, less than or equal to about 0.91:1, less than or equal to about 0.9:1, less than or equal to about 0.89:1, less than or equal to about 0.87:1, less than or equal to about 0.85:1, less than or equal to about 0.83:1, less than or equal to about 0.82:1, less than or equal to about 0.8:1, less than or equal to about 0.79:1, less than or equal to about 0.76:1, or less than or equal to about 0.74:1.

In an embodiment, in the semiconductor nanoparticle or the light-emitting layer, a mole ratio of sulfur to a sum of selenium and sulfur [S:(Se+S)] may be less than or equal to about 0.31:1, less than or equal to about 0.3:1, less than or equal to about 0.29:1, less than or equal to about 0.28:1, less than or equal to about 0.25:1, or less than or equal to about 0.2:1.

In an embodiment, in the semiconductor nanoparticle or the light-emitting layer, a mole ratio of sulfur to a sum of selenium and sulfur [S:(Se+S)] may be greater than about 0:1, greater than or equal to about 0.01:1, greater than or equal to about 0.03:1, greater than or equal to about 0.05:1, greater than or equal to about 0.07:1, greater than or equal to about 0.08:1, greater than or equal to about 0.1:1, greater than or equal to about 0.11:1, greater than or equal to about 0.13:1, greater than or equal to about 0.15:1, greater than or equal to about 0.17:1, greater than or equal to about 0.18:1, greater than or equal to about 0.2:1, greater than or equal to about 0.21:1, greater than or equal to about 0.23:1, or greater than or equal to about 0.26:1.

In an embodiment, at least a portion of (or an entire of) the surface of the core (e.g., the first semiconductor nanocrystal) of the plurality of semiconductor nanoparticles may include the second semiconductor nanocrystal. In an embodiment, the second semiconductor nanocrystal may be disposed on the entire of the surface of the core.

The semiconductor nanoparticle (for example, the quantum dot) has a core-shell structure including a core and a shell disposed on the core. In the core-shell structure, the first semiconductor nanocrystal is included in the core and the second semiconductor nanocrystal including the zinc chalcogenide such as the first zinc chalcogenide, the second zinc chalcogenide, or a combination thereof, is included in the shell.

The first semiconductor nanocrystal or the core(s) may include an indium phosphide, an indium zinc phosphide, or a combination thereof. The core may have a size (or an average size) of greater than or equal to about 1 nm, greater than or equal to about 1.5 nm, greater than or equal to about 1.9 nm, greater than or equal to about 2 nm, greater than or equal to about 2.1 nm, greater than or equal to about 2.3 nm, or greater than or equal to about 2.5 nm. The core may have a size (or an average size) of less than or equal to about 5 nm, less than or equal to about 4 nm, less than or equal to about 3.5 nm, less than or equal to about 3 nm, less than or equal to about 2.7 nm, or less than or equal to about 2.5 nm.

In an embodiment, a size of the nanoparticle or the nanocrystal may be determined by using a result (e.g., an image) of a (transmission) electron microscopy analysis and any suitable image analysis computer program (e.g., Image J).

The second semiconductor nanocrystal or the shell including the same may include a zinc selenide, a zinc sulfide, or a combination thereof. The second semiconductor nanocrystal or the shell may include a zinc selenide sulfide. In an embodiment, the second semiconductor nanocrystal or the shell (or each of the shell layers in a multi-layered shell) may include a gradient alloy having a composition varying in a direction of a radius, e.g., a radial direction from the core toward an outermost surface of the quantum dot. In an embodiment, the shell or the second semiconductor nanocrystal may have a concentration of sulfur increasing in a direction of a radius, e.g., a radial direction from the core toward an outermost surface of the nanostructure. In an embodiment, in the shell or the second semiconductor nanocrystal, a concentration of sulfur may increase in a direction of a radius, e.g., a radial direction from the core toward an outermost surface of the nanostructure.

In an embodiment, the shell may be a multi-layered shell including two or more layers. In the multi-layered shell, adjacent two layers may have different compositions from each other. The multi-layered shell may include a first shell layer including zinc, selenium, and optionally sulfur, and a second shell layer disposed on the first shell layer, having a different composition from the first shell layer, and including zinc, sulfur, and optionally selenium. The first shell layer may be disposed directly on the core. The first shell layer may be disposed between the core and the second shell layer. The first shell layer may include a zinc selenide. The second shell layer may include a zinc sulfide.

The first shell layer may include ZnSe, ZnSeS, or a combination thereof. The first shell layer may include or may not include sulfur. The second shell layer may include ZnS, ZnSeS, or a combination thereof. The second shell layer may be an outermost shell layer of the nanostructure. The second shell layer may include or may not include selenium.

A thickness of the shell or the second semiconductor nanocrystal may be greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.2 nm, greater than or equal to about 3.3 nm, greater than or equal to about 3.4 nm, greater than or equal to about 3.5 nm, greater than or equal to about 3.6 nm, greater than or equal to about 3.7 nm, greater than or equal to about 3.8 nm, greater than or equal to about 3.9 nm, greater than or equal to about 4 nm, greater than or equal to about 4.1 nm, or greater than or equal to about 4.3 nm. A thickness of the shell or the second semiconductor nanocrystal may be less than or equal to about 6 nm, less than or equal to about 5.5 nm, less than or equal to about 5 nm, less than or equal to about 4.9 nm, less than or equal to about 4.5 nm, less than or equal to about 4 nm, or less than or equal to about 3.5 nm.

In an embodiment, the semiconductor nanoparticle may include the second semiconductor nanocrystal having the thickness and the composition described herein, exhibiting improved luminous properties together with a suppressed auger recombination.

The semiconductor nanoparticle of the embodiment may be prepared by the method described herein, including the relatively thick second semiconductor nanocrystal with maintaining an improved coating quality.

In the multi-layered shell, a thickness of the first shell layer (e.g., inner layer, or a zinc selenide) may be greater than or equal to about 2.1 nm, greater than or equal to about 2.2 nm, greater than or equal to about 2.3 nm, greater than or equal to about 2.4 nm, greater than or equal to 2.5 nm, greater than or equal to about 2.7 nm, greater than or equal to about 2.9 nm, greater than or equal to about 3 nm, greater than or equal to about 3.1 nm, greater than or equal to about 3.2 nm, greater than or equal to about 3.4 nm, greater than or equal to about 3.6 nm, greater than or equal to about 3.8 nm, or greater than or equal to about 4 nm. The thickness of the first shell layer may be less than or equal to about 6 nm, less than or equal to about 5.5 nm, less than or equal to about 5 nm, less than or equal to about 4.8 nm, less than or equal to about 4.5 nm, less than or equal to about 4 nm, less than or equal to about 3.5 nm, less than or equal to about 3 nm, less than or equal to about 2.5 nm, or less than or equal to about 2.3 nm.

The present inventors have found that, in case of the semiconductor nanoparticle prepared in a conventional method, an increased thickness (for example that is greater than or equal to about 2 nm, or greater than or equal to about 2.5 nm) of the first shell layer (or the inner layer including a ZnSe) may lead to a sharp drop in an optical property (e.g., a PLQY) thereof. For example, the semiconductor nanoparticle prepared in the conventional method may exhibit a sharp drop (for example, that is greater than or equal to about 4%, greater than or equal to about 8%, or even at least 10%) in a quantum efficiency or yield from its QY achievable with a ZnSe layer having a thickness of less than 2 nm. Surprisingly, the present inventors have discovered that by adopting the method described herein (involving the use of the additive (for example having a relatively high reactivity), the intermediate separation during the shell formation, or the like), the semiconductor nanoparticle thus prepared include the first shell layer or the inner layer with a thickness of greater than 2 nm, for example at least about 2.5 nm, or at least about 2.7 nm and about 4 nm, about 3.5 nm, or about 3 nm and may also exhibit substantially no decrease or a very limited decrease in the luminous efficiency such as a PLQY. The present inventors have also found that the second shell layer (or the outer layer for example including a zinc sulfide) may be formed more uniformly on the first shell layer that is formed according to the method of the embodiment, resulting in the semiconductor nanoparticle including more uniformly coated ZnS layer for example, as determined by an electron energy loss spectroscopy (EELS) analysis.

A thickness of the second shell layer (e.g., outer layer, for example including a zinc sulfide) may be greater than or equal to about 0.1 nm, greater than or equal to about 0.2 nm, greater than or equal to about 0.25 nm, greater than or equal to about 0.3 nm, greater than or equal to about 0.5 nm, greater than or equal to about 0.7 nm, greater than or equal to about 0.9 nm, greater than or equal to about 1 nm, greater than or equal to about 1.1 nm, greater than or equal to about 1.3 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, or greater than or equal to about 3 nm. The thickness of the second shell layer may be less than or equal to about 4 nm, less than or equal to about 1.5 nm, less than or equal to about 1 nm, less than or equal to about 0.7 nm, or less than or equal to about 0.5 nm.

The first semiconductor nanocrystal or the core may not include manganese, copper, or a combination thereof. The first semiconductor nanocrystal or the core may include or may not include tellurium.

In an embodiment, the semiconductor nanoparticle may be configured to emit green light and may have an increased (average) size. In an embodiment, a size or an average size of the semiconductor nanoparticle may be greater than or equal to about 7.3 nm, greater than or equal to about 7.4 nm, greater than or equal to 7.5 nm, greater than or equal to about 7.6 nm, greater than or equal to about 7.7 nm, greater than or equal to about 7.8 nm, greater than or equal to about 7.9 nm, greater than or equal to 8 nm, greater than or equal to about 8.1 nm, greater than or equal to about 8.2 nm, greater than or equal to about 8.3 nm, greater than or equal to about 8.4 nm, greater than or equal to about 8.5 nm, greater than or equal to about 8.6 nm, greater than or equal to about 8.7 nm, greater than or equal to about 8.8 nm, greater than or equal to about 8.9 nm, greater than or equal to about 9 nm, greater than or equal to about 9.5 nm, or greater than or equal to about 10 nm. In an embodiment, the size or the average size of the semiconductor nanoparticle may be less than or equal to about 50 nm, less than or equal to about 45 nm, less than or equal to about 40 nm, less than or equal to about 35 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, less than or equal to about 12 nm, less than or equal to about 11 nm, or less than or equal to 10 nm.

In an embodiment, the semiconductor nanoparticle may show, e.g., exhibit, a relatively uniform particle size distribution (e.g., a standard deviation), which may be less than or equal to 10%, less than or equal to about 9%, less than or equal to about 8%, less than or equal to about 7%, less than or equal to about 6%, or less than or equal to about 5% of the average size thereof. In an aspect, the standard deviation may be greater than or equal to 0%, greater than or equal to about 1%, greater than or equal to about 2%, or greater than or equal to about 3% of the average size thereof.

In an embodiment, the semiconductor nanoparticle in the light-emitting layer may have a controlled particle shape. In an embodiment, as determined in a two-dimensional image obtained by an electron microscopy analysis, the semiconductor nanoparticle in the light-emitting layer may exhibit an average value of squareness of greater than or equal to about 0.6, the squareness being defined by the following equation:

$$Squareness = A/C$$

wherein A is an area of a given semiconductor nanoparticle in the two-dimensional image, and C is an area of a smallest square that covers the area of a given semiconductor nanoparticle.

The average value of the squareness may be greater than or equal to about 0.65, greater than or equal to about 0.7, or greater than or equal to about 0.78. The average value of the squareness may be less than or equal to about 0.95, less than or equal to about 0.9, less than or equal to about 0.85, less than or equal to about 0.8, or less than or equal to about 0.7.

With regard to the squareness, the area C may be determined by $c^2$ wherein c is a side length of the smallest square. In an embodiment, the smallest square may be a circumscribed square.

Determination of the smallest square or the side length of the smallest square may be readily and clearly made according to a given particle shape. For a shape of a circle or an ellipse, the c may be a diameter or a length of the major axis. For a shape of a rectangle, the c may be a length of a longer side length. The smallest square may be readily and reproducibly determined for each of the particles in any commercially available image handling computer program (for example, universally provided by Microsoft Windows). The area A is divided with the area C to provide the squareness.

The two-dimensional image may be a high-resolution transmission electron microscopy image wherein a resolution may be from about 0.2 nm to about 0.08 nm and the magnification may be from about x2,000,000 to about x10,000,000, about x3,000,000 to about x7,000,000, for example, 5,000,000 times.

High-resolution transmission electron microscopy (HRTEM) is an imaging mode of specialized transmission electron microscopes that allows for direct imaging of the atomic structure of a given nanostructure. The HRTEM is substantially identical to transmission electron microscopy (TEM) imaging except that the magnifications used are high enough to see the lattice spacing of inorganic materials (typically on the order of several angstroms (Å)). Such lattice spacings can easily be recorded onto film at moderate magnifications.

A circularity is a shape factor measuring how close to circle a cross-section of a particle taking into consideration of a smoothness of perimeter is. The circularity may be determined by using a two-dimensional image obtained by an electron microscopy analysis and using the following equation:

$$4\pi \times \frac{Area}{[Perimeter]^2} \quad ,$$

wherein Area is an area of a two-dimensional image of an individual semiconductor nanoparticle, and
Perimeter is a circumference of a two-dimensional image of an individual semiconductor nanoparticle.

A solidity (S) is defined by the following equation and may be a value determined by dividing an image area with a convex hull area:

$$S = \frac{A}{A_C}$$

wherein A is an area of a two-dimensional image of an individual semiconductor nanoparticle, and
Ac is a convex hull area of a two-dimensional image of an individual semiconductor nanoparticle.

A roundness is defined by the following equation:

$$\frac{4 \times \text{area}}{\pi \times (\text{major axis})^2},$$

wherein area is an area of a two-dimensional image of an individual semiconductor nanoparticle, and
Major Axis is a longest dimension (e.g., diameter) of an individual semiconductor nanoparticle.

The shape factors (e.g., the circularity, the solidity, or the roundness) may be obtained readily and reproducibility from a two-dimensional electron microcopy image of the particles using a universal image analysis program (e.g., Image J developed by NIH) and a manual of the program producer (e.g., Image J User Guide IJ 1.46r) or an equivalent in-house image program made by a coding language (e.g., a commercially available coding language such as MATLAB).

In an embodiment, the semiconductor nanoparticle may have an average value of a roundness that is greater than or equal to 0.77, greater than or equal to about 0.8, greater than or equal to about 0.85, greater than or equal to about 0.88, or greater than or equal to about 0.9 and less than or equal to about 1, less than or equal to about 0.98, less than or equal to about 0.97, less than or equal to about 0.95, less than or equal to about 0.93, or less than or equal to about 0.89.

In an embodiment, the semiconductor nanoparticle may have an average value of a solidity that is greater than or equal to about 0.9, greater than or equal to about 0.95, greater than or equal to about 0.97, and less than or equal to about 1, or less than or equal to about 0.98.

In an embodiment, the semiconductor nanoparticle may have an average value of a circularity that is greater than or equal to about 0.77, greater than or equal to about 0.8, greater than or equal to about 0.85, greater than or equal to about 0.88, or greater than or equal to about 0.9 and less than or equal to about 1, less than or equal to about 0.98, less than or equal to about 0.97, less than or equal to about 0.95, less than or equal to about 0.93, or less than or equal to about 0.89.

The semiconductor nanoparticle emits a green light. An emission peak wavelength of the green light may be the same as described herein. The semiconductor nanoparticle may exhibit a quantum yield or efficiency (e.g., an absolute quantum yield, QY) of greater than or equal to 90%, greater than or equal to about 91%, greater than or equal to about 92%, greater than or equal to about 93%, greater than or equal to about 94%, greater than or equal to about 95%, greater than or equal to about 96%, greater than or equal to about 97%, greater than or equal to about 98%, or greater than or equal to about 99% . The quantum yield or efficiency may be from about 75% to about 100%, from about 80% to about 99%, from about 85% to about 98%, from about 90% to about 95%. In an aspect, the semiconductor nanoparticle may exhibit a quantum yield (e.g., an absolute quantum yield, QY) of greater than or equal to about 65%. In an aspect, the semiconductor nanoparticles may exhibit the quantum yield of greater than or equal to about 65%, greater than or equal to about 70%, greater than or equal to about 75%, greater than or equal to about 80%, greater than or equal to about 85%, greater than or equal to about 88%.

In an ultraviolet-visible (UV-vis) absorption spectrum, the semiconductor nanoparticle may exhibit a valley depth (VD) of greater than or equal to about 0.3, greater than or equal to about 0.32, greater than or equal to 0.35, greater than or equal to about 0.38, greater than or equal to about 0.40, greater than or equal to about 0.41, greater than or equal to about 0.42, greater than or equal to about 0.43, greater than or equal to about 0.44, greater than or equal to about 0.45, or greater than or equal to about 0.46, the valley depth (VD) being defined by the following equation:

$$(Abs_{first} - Abs_{valley})/ Abs_{first} = VD$$

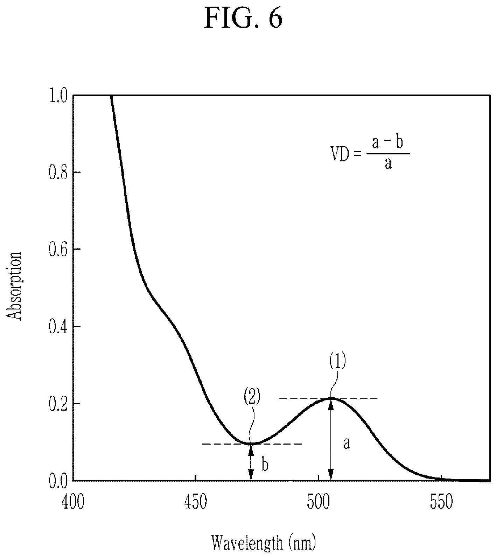

wherein $Abs_{first}$ is an absorbance at a wavelength of a first absorption peak and $Abs_{valley}$ is an absorbance at a lowest point of a valley adjacent to the first absorption peak. Referring to FIG. 6, the absorbance at a wavelength of a first absorption peak is a and the absorbance at a lowest point of a valley adjacent to the first absorption peak is b.

The valley depth may be less than or equal to about 0.7, less than or equal to about 0.65, less than or equal to about 0.6, less than or equal to about 0.55, or less than or equal to about 0.5.

The present inventors have found that, in case of the semiconductor nanoparticle prepared in a conventional method, an increased thickness (for example that is greater than or equal to about 2 nm, or greater than or equal to about 2.5 nm) of the first shell layer (or the inner layer including ZnSe) may lead to a sharp drop in a valley depth thereof. For example, the semiconductor nanoparticle prepared in the conventional method may exhibit a sharp drop (for example, by greater than or equal to about 8 %, greater than or equal to about 22 %, or even 26%) in a valley depth from its highest valley depth achievable with a ZnSe layer having a thickness of less than 2 nm. Surprisingly, the present inventors have discovered that by adopting the method described herein (involving the use of the additive, the intermediate separation during the shell formation, or the like), the semiconductor nanoparticle thus prepared include the first shell layer or the inner layer with a thickness of greater than 2 nm, for example at least about 2.5 nm, or at least about 2.7 nm and about 4 nm, about 3.5 nm, or about 3 nm and may also exhibit substantially no decrease or even an increase in the valley depth.

The first absorption peak of the semiconductor nanoparticle may be present in a range of, for example, greater than or equal to 450 nm, greater than or equal to about 470 nm, greater than or equal to about 480 nm, greater than or equal to about 490 nm, greater than or equal to about 500 nm, greater than or equal to about 505 nm, or greater than or equal to about 510 nm and less than or equal to about 550 nm, less than or equal to about 540 nm, less than or equal to about 530 nm, less than or equal to about 520 nm, or less than or equal to about 515 nm.

In the UV-vis absorption spectrum of the semiconductor nanoparticle of an embodiment, the valley or the lowest point thereof may be appeared at a wavelength lower, e.g., shorter, than the first absorption peak wavelength. The lowest point of the valley in the UV-Vis absorption spectrum of the semiconductor nanoparticle may be present in a range of, greater than or equal to about 470 nm, greater than or equal to about 475 nm, greater than or equal to about 480 nm, greater than or equal to about 485 nm, greater than or equal to about 490 nm, greater than or equal to about 495 nm, greater than or equal to about 500 nm, or greater than or equal to about 505 nm and less than or equal to about 520 nm, less than or equal to about 515 nm, less than or equal to about 500 nm, less than or equal to about 490 nm, or less than or equal to about 485 nm.

In a UV-Vis absorption spectrum of the semiconductor nanoparticle of an embodiment, a ratio of an absorbance at a wavelength of 450 nm to an absorbance at the first absorption peak may be greater than or equal to 2:1, greater than or equal to about 2.1:1, greater than or equal to about 2.2:1, greater than or equal to about 2.3:1, greater than or equal to about 2.4:1, greater than or equal to about 2.5:1, greater than or equal to about 2.6:1, or greater than or equal to about 2.7:1. In an embodiment, the ratio of an absorbance at a wavelength of 450 nm to an absorbance at the first absorption peak may be less than or equal to about 5:1, less than or equal to about 4:1, or less than or equal to about 3:1.

The semiconductor nanoparticle or the light-emitting layer may exhibit a maximum luminescent peak having a full width at half maximum (FWHM) of less than or equal to about 45 nm. The full width at half maximum may be less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, less than or equal to about 35 nm, less than or equal to about 34 nm, or less than or equal to about 33 nm. The full width at half maximum may be greater than or equal to about 2 nm, greater than or equal to about 5 nm, greater than or equal to about 10 nm, greater than or equal to about 12 nm, or greater than or equal to about 15 nm.

As used herein, unless stated to the contrary, an optical feature such as PLQY, UV absorption properties, or FWHM, may be measured at room temperature (e.g., about 20 °C to 25 °C).

In an embodiment, the semiconductor nanoparticle may have a wavelength difference in a Decay Associated Spectrum analysis (DAS analysis) of less than or equal to 5 nm, less than or equal to about 4.5 nm, less than or equal to about 4 nm, less than or equal to about 3.5 nm, or less than or equal to about 3 nm. The wavelength difference may be greater than or equal to about 0.5 nm, greater than or equal to about 1 nm, greater than or equal to about 1.5 nm, or greater than or equal to about 2 nm.

In an electroluminescent device including the semiconductor nanoparticle, as a voltage is applied to a light-emitting layer, an electron and a hole supplied from the electrodes may be recombined in the semiconductor nanoparticle (e.g., its core), whereby a light of a desired wavelength may be emitted. The present inventors have found that, on the recombination of the electron-hole occurring in the light-emitting layer of the electroluminescent device, green light-emitting semiconductor nanoparticles prepared in the prior art method exhibit a considerable level of Fluorescence Resonance Energy Transfer (FRET) , which can be determined in the wavelength difference in the DAS analysis (for example, a DAS wavelength difference of greater than or equal to about 6 nm, or 9 nm). The wavelength difference in the DAS analysis may be a difference between an initial wavelength (i.e., an emission peak wavelength at 0 nanosecond) and an emission peak wavelength at a predetermined time for example at 20 nanoseconds. Without wishing to be bound by any theory, it is believed that such a FRET phenomenon may be linked to the electroluminescent properties (for example, a luminous efficiency) and lifetime properties. The semiconductor nanoparticle of an embodiment may exhibit a relatively low level of the DAS wavelength difference (for example, that is less than or equal to about 4 nm), in comparison with the semiconductor nanoparticle prepared in the prior art. In an embodiment, the wavelength difference in the DAS analysis may be similar to a difference between a photoluminescent peak wavelength of the semiconductor nanoparticle of an embodiment (in a solution) and an electroluminescent peak wavelength of the light emitting layer of the semiconductor nanoparticle of the embodiment.

An embodiment is related to the semiconductor nanoparticle (e.g., a population thereof) described herein. Details (e.g., mole ratios, structural features, or other features) described herein for the semiconductor nanoparticle (e.g., a population thereof) may be applied to the embodiment, as well. In an embodiment, the semiconductor nanoparticle may not include cadmium, lead, or a combination thereof. The semiconductor nanoparticle includes a semiconductor nanocrystal including indium, phosphorus, zinc, selenium, and sulfur. The semiconductor nanoparticle or the semiconductor nanocrystal includes a first semiconductor nanocrystal including a Group III-V compound which may include indium, phosphorus, and optionally zinc, and a second semiconductor nanocrystal including a zinc chalcogenide, wherein the zinc chalcogenide may include zinc, selenium, and sulfur. In the semiconductor nanoparticle or in the semiconductor nanocrystal, a mole ratio of zinc to indium (Zn:In) is greater than or equal to 60:1, for example greater than or equal to about 67:1, greater than or equal to about 70:1, or greater than or equal to about 72:1. In the semiconductor nanoparticle or in the semiconductor nanocrystal, the mole ratio of zinc to indium is less than or equal to about 250:1, for example less than or equal to about 110:1, less than or equal to about 98:1, less than or equal to about 95:1. In the semiconductor nanoparticle or in the semiconductor nanocrystal, a mole ratio of indium to a sum of sulfur and selenium may be less than or equal to about 0.05:1, less than or equal to about 0.04:1, less than or equal to 0.03:1, less than or equal to about 0.02:1, less than or equal to about 0.018:1, or less than or equal to about 0.015:1 and a mole ratio of sulfur to selenium may be less than or equal to 0.5:1, less than or equal to about 0.4:1, or less than or equal to about 0.3:1. The mole ratio of indium to a sum of sulfur and selenium may be greater than or equal to 0.0005:1, greater than or equal to about 0.001:1, greater than or equal to about 0.002:1, or greater than or equal to about 0.003:1. In the semiconductor nanoparticle,. In an aspect a mole ratio of selenium to indium may be greater than or equal to 51:1, greater than or equal to about 53:1, or greater than or equal to about 55:1, and less than or equal to about 100:1, less than or equal to about 90:1, or less than or equal to about 80:1. The above features or other features such as mole ratios, structural features, or the like are the same as described herein for the semiconductor nanoparticle (e.g., a population thereof).

The semiconductor nanoparticle (e.g., included in the light-emitting layer) is prepared by a method as described herein. The method includes: in the presence of an organic ligand and a nanoparticle (e.g., including a core) that includes the first semiconductor nanocrystal (e.g., in an organic solvent), conducting a reaction between a zinc precursor and a chalcogen precursor at a temperature of greater than 320 °C, for example, greater than or equal to about 330 °C, greater than or equal to about 335 °C, or greater than or equal to about 340 °C, to form a second semiconductor nanocrystal including a zinc chalcogenide, wherein the chalcogen precursor includes a selenium precursor and a sulfur precursor, and wherein in the method, a reaction between the zinc precursor and the selenium precursor is conducted in the presence of an additive, and the additive includes a sulfur compound (e.g., a thiol compound) that is different from the sulfur precursor, an alkali metal compound, a zinc compound that is different from the zinc precursor, a superhydride compound, a gallium compound, or a combination thereof.

In the method of an embodiment, an amount of the zinc precursor, an amount of the selenium precursor, and an amount of the sulfur precursor may be controlled so that the resulting semiconductor nanoparticle may have a composition described herein. The mole ratio of zinc to indium is greater than or equal to 60:1, for example greater than or equal to about 67:1, or greater than or equal to about 70:1. The mole ratio of indium to a sum of sulfur and selenium is less than or equal to 0.03:1, and the mole ratio of sulfur to selenium may be less than or equal to 0.5:1.

In the semiconductor nanoparticle prepared in the embodiment, the mole ratio of zinc to indium, the mole ratio of indium to a sum of sulfur and selenium, and the mole ratio of sulfur to selenium are the same as described herein. In the semiconductor nanoparticle prepared in the embodiment, the mole ratios between the elements constituting the semiconductor nanoparticle are the same as described herein.

The method may include contacting (e.g., adding) the nanoparticle, the selenium precursor, and the additive with (e.g., to) a reaction medium including the zinc precursor. The reaction medium may further include the organic solvent and the organic ligand.

The method (or the reaction between the zinc precursor and the chalcogen precursor) may include reacting the zinc precursor with the selenium precursor (and optionally the sulfur precursor) to form an inner layer (e.g., a first shell layer) and then reacting the zinc precursor with the sulfur precursor (and optionally the selenium precursor) to form an outer layer (e.g., a second shell layer) on the inner layer.

The additive may include the sulfur compound (for example, a thiol compound or a sulfide compound) and the alkali metal compound.

The sulfur compound may include a C1 to C30 (C8 to C20 or C10 to C18) thiol compound (for example, octane thiol, dodecane thiol), a bis trimethyl silylsulfide, a bis trimethylsilyl alkyl sulfide, or a combination thereof.

The gallium compound may include a C1 to C30 carboxylic acid gallium salt (for example, gallium oleate, gallium stearate, or gallium palmitate), an alkylated gallium (for example, a trialkyl gallium such as triethyl gallium), or a combination thereof.

The alkali metal compound may include a C1 to C30 carboxylic acid alkali metal salt (for example, lithium oleate, sodium oleate, potassium oleate, lithium stearate, sodium stearate, potassium stearate, lithium palmitate, sodium palmitate, or potassium palmitate).

The zinc compound may include a zinc halide such as zinc chloride, zinc bromide, zinc iodide, or zinc fluoride, an alkylated zinc such as diethyl zinc, dimethyl zinc, or dipropyl zinc, or a combination thereof.

The superhydride compound may include a lithium trialkyl borohydride (e.g., a lithium triethylborohydride)

The compound for the additive may be used alone or in a mixture of at least two compounds. In the method of an embodiment, the additive may include the sulfur compound (for example, a thiol compound); and optionally a gallium compound, an alkali metal compound, or a combination thereof.

Without wishing to be bound by any theory, the additive may be used in combination with a condition and/or a manner described herein (for example, a reaction temperature, a manner of adding the precursors, a mole ratio among the precursors, and/or an intermediate separation) to increase a rate of forming a second semiconductor nanocrystal (e.g., a coating rate), whereby it is believed that generation of an oxide may be suppressed or avoided and/or a metal passivation may occur during the formation of the semiconductor nanocrystal (e.g., the second semiconductor nanocrystal), and thus according to the method of an embodiment, the second semiconductor nanocrystal with an increased fraction or an increased thickness may be provided relatively uniformly on the first semiconductor nanocrystal.

Details of the first semiconductor nanocrystal are the same as described herein. The first semiconductor nanocrystal may be prepared in an appropriate manner. In an embodiment, the core may be commercially available or may be prepared by any proper method.

In an embodiment, the core may be synthesized in a hot injection manner wherein a solution including a metal precursor (e.g., an indium precursor) and optionally a ligand is heated at a high temperature (e.g., of greater than or equal to about 200 °C) and then a phosphorous precursor is injected into the heated hot solution. In an embodiment, the core may be synthesized in a heating up manner wherein a phosphorous precursor is injected to a reaction system, and a resulting mixture is heated.

A time for a core formation reaction is not particularly limited and selected appropriately. The time for a core formation reaction may be from about 1 minutes to about 100 minutes, from about 10 minutes to about 80 minutes, from about 15 minutes to about 60 minutes, from about 25 minutes to about 45 minutes, from about 30 minutes to about 35 minutes, or a combination thereof. A reaction temperature of the core formation reaction is not particularly limited and may be selected appropriately. The reaction temperature of the core formation reaction may be from about 200 °C to about 300 °C, from about 240 °C to about 290 °C, from about 250 °C to about 280 °C, or a combination thereof.

In an embodiment, a zinc precursor, a solvent, and optionally an organic ligand may be heated under vacuum (or vacuum-treated) at a predetermined temperature (e.g., at a temperature of greater than or equal to about 100 °C) to form a reaction medium, an atmosphere of a reactor including the reaction medium may be changed into an inert gas and be heated at a first temperature (for example, greater than or equal to about 80°C, greater than or equal to about 100 °C, for example, greater than or equal to about 120°C, greater than or equal to about 130°C, greater than or equal to about 140°C, greater than or equal to about 150 °C, greater than or equal to about 160 °C, greater than or equal to about 170 °C, greater than or equal to about 180°C, greater than or equal to about 190°C, greater than or equal to about 200°C, greater than or equal to about 210°C, greater than or equal to about 220 °C, greater than or equal to about 230 °C, or greater than or equal to about 240 °C and less than or equal to about a reaction temperature). The first semiconductor nanocrystal and the precursors for the second semiconductor nanocrystal (e.g., the sulfur precursor and the selenium precursor, and optionally the zinc precursor) may be added or injected to the reaction medium to carry out a reaction, during which the additive may be added thereto. The first temperature may be greater than or equal to about 100 °C, greater than or equal to about 150°C, greater than or equal to about 180°C, greater than or equal to about 200 °C, or greater than or equal to about 240 °C. The first temperature may be less than or equal to about 280°C, less than or equal to about 250 °C, less than or equal to about 230°C, less than or equal to about 200°C, less than or equal to about 190°C, or less than or equal to about 150 °C.

The present inventors have found that in the formation of the second semiconductor nanocrystal including a zinc chalcogenide in the presence of the first semiconductor nanocrystal designed to emit a green light, there can be a limit in an increase of a thickness of the second semiconductor nanocrystal. The present inventors have found that it is very difficult for a final semiconductor nanoparticle having a shell of a thickness of at least about 2.5 nm (for example, a 7 monolayers of a zinc selenide shell layer) to have a desired coating quality. The present inventors have found that as the thickness of the shell layer increases into the above range, the final semiconductor nanoparticle includes a pod shape (for example, an unwanted circularity or roundness), which may lead to an adverse effect on the luminous properties (for example, resulting in an efficiency decrease or an emission peak wavelength shift to a longer wavelength). Without wishing to be bound by any theory, it is believed that the formation of the second semiconductor nanocrystal on the first semiconductor nanocrystal results in generation of a considerable amount of a phosphorus oxide on the interface therebetween, which may in turn have an adverse effect on the coating quality of the second semiconductor nanocrystal.

Surprisingly, the present inventors have found that in a method of an embodiment, the additive being present or being added in the reaction system may effectively prevent or suppress the formation of the phosphorus oxide, and in the final semiconductor nanoparticle, the second semiconductor nanocrystal having the composition and the thickness described herein may be formed. Without wishing to be bound by any theory, the additive added in the manner described herein may substantially suppress a reaction between the phosphorus precursor and the oxygen and whereby the second semiconductor nanocrystal may be provided without the formation of a substantial amount of the phosphorus oxide. Without wishing to be bound by any theory, the second semiconductor nanocrystal formed according to the method described herein may contribute to causing the final semiconductor nanoparticle included in the light-emitting layer of the electroluminescent device to exhibit the improved electroluminescent properties and the improved lifespan feature.

In an embodiment, the additive may be added prior to the addition of the selenium precursor. In an embodiment, the additive may be added after (or directly after) the addition of the selenium precursor. In an embodiment, the additive and the selenium precursor may be added to the reaction system simultaneously. In an embodiment, the additive may be added prior to or after the addition of the sulfur precursor. In an embodiment, the additive may be added together with the sulfur precursor. In an embodiment, the additive may be added at least twice among the aforementioned times. In the method of an embodiment, the selenium precursor may be added prior to the addition of the sulfur precursor. The order of adding the chalcogen precursors may be determined taking into consideration the composition and the structure of the second semiconductor nanocrystal in the final semiconductor nanoparticle.

In an embodiment, the zinc precursor may be reacted with the selenium precursor and optionally the sulfur precursor to form a first shell layer (the inner layer) and then the zinc precursor may be reacted with the sulfur precursor and optionally the selenium precursor to form a second shell layer (the outer layer). The additive may be added to the reaction system (e.g., medium) during the formation of the first shell layer, after the formation of the first shell layer, or during the formation of the second shell layer.

An amount of the additive (or of each of the additives when at least two compounds are used) may be, per 100 moles of the selenium precursor, greater than or equal to about 0.1 mole, greater than or equal to about 0.5 moles, greater than or equal to about 0.8 moles, greater than or equal to about 1 mole, greater than or equal to about 1.3 moles, greater than or equal to about 1.5 moles, 2 moles, greater than or equal to about 3 moles, greater than or equal to about 4 moles, greater than or equal to about 5 moles, greater than or equal to about 10 moles, greater than or equal to about 15 moles, greater than or equal to about 20 moles, or greater than or equal to about 25 moles. The amount of the additive may be, per 100 moles of the selenium precursor, less than or equal to about 28 moles, less than or equal to about 20 moles, less than or equal to about 18 moles, less than or equal to about 15 moles, less than or equal to about 10 moles, less than or equal to about 9 moles, less than or equal to about 8 moles, less than or equal to about 7 moles, less than or equal to about 6 moles, less than or equal to about 5 moles, less than or equal to about 4.5 moles, less than or equal to about 4 moles, less than or equal to about 3.5 moles, less than or equal to about 3 moles, less than or equal to about 2.8 moles, less than or equal to about 2 moles, less than or equal to about 1 mole, or less than or equal to about 0.5 mole.

The reaction temperature is greater than 320 °C, for example greater than or equal to about 325 °C, greater than or equal to about 330°C, greater than or equal to about 335°C, or greater than or equal to about 340 °C. The reaction temperature may be less than or equal to about 380 °C, less than or equal to about 370°C, less than or equal to about 360°C, or less than or equal to about 350 °C.

In an embodiment, the selenium precursor may be added or injected in a split manner (e.g., not all at once), intermittently to a reaction medium at least two times, in a different aliquot each time, respectively, optionally together with a zinc precursor. In an embodiment, the sulfur precursor may be added or injected in a split manner (e.g., not all at once), intermittently to a reaction medium at least two times, in a different aliquot each time, respectively, optionally together with a zinc precursor. The selenium precursor and the sulfur precursor may be added separately. The selenium precursor and the sulfur precursor may be added without being mixed together. In an embodiment, a predetermined amount of the selenium precursor may be added first and then addition of the sulfur precursor (for example in the split manner) to the reaction medium may be started.

In an embodiment, the selenium precursor may be added at least twice, at least three times, at least four times, at least five times, at least six times, or at least seven times in a different aliquot each time. In an embodiment, together with the use of the additive, adding the selenium precursor in the split manner in multiple times (for example at least four times or at least five times) may further contribute to forming the second semiconductor nanocrystal with a desired quality (such as the composition, the thickness, or the coating uniformity). In the addition of the selenium precursor in the split manner, a second aliquot added secondly may be greater than a first aliquot added firstly. In the addition of the selenium precursor, a third aliquot added thirdly may be greater than the second aliquot added secondly. In an embodiment, the sulfur precursor may be added once or at least twice, at least three times, or at least four times in the same aliquot or in aliquots different (e.g., gradually increasing or gradually decreasing) each time.

For each of the precursors, an aliquot added each time may be controlled taking into consideration the types of the precursors, a reaction temperature, and a desired composition of the semiconductor nanoparticles.

The method may further include an intermediate separation during the formation of the second semiconductor nanocrystal. In the intermediate separation, the formed nanoparticle is separated for example by a non-solvent precipitation and optionally washed with an organic solvent, and then added again to a reaction medium for forming the second semiconductor nanocrystal. The intermediate separation may be carried out at least once or at least two times.

The washing is the same as described herein.

In an embodiment, during the formation of the second semiconductor nanocrystal, the semiconductor nanoparticle may be separated from a reaction system one or more times and washed with a washing solvent described herein. The intermediate separation may be carried out at an appropriate time during the formation of the second semiconductor nanocrystal. In an embodiment, the intermediate separation may be conducted after a semiconductor nanocrystal including a zinc selenide is formed with a predetermined thickness (for example, of at least three monolayers, five monolayers, seven monolayers, or ten monolayers). The intermediate separation may be conducted between (e.g., after) the formation of the first shell layer and (e.g., prior to or directly before) the second shell layer. In an embodiment, the intermediate separation may be carried out during the formation of the semiconductor nanocrystal including a zinc sulfide. The intermediate separation may be carried out once, twice, three times, four times, five times, or more.

Without wishing to be bound by any theory, the formation of the second semiconductor nanocrystal, the use of the additive and the synthesis technology described herein (for example, adding the selenium precursor in a split manner at different amounts of aliquots and increasing the reaction temperature) may be combined appropriately to provide the second semiconductor nanocrystal with more improved coating quality, whereby the final semiconductor nanoparticle may exhibit a uniform and controlled shape together with an increased size.

In an embodiment, the zinc precursor may include a Zn metal powder, an alkylated Zn compound, Zn alkoxide, Zn carboxylate, Zn nitrate, Zn perchlorate, Zn sulfate, Zn acetylacetonate, Zn halide (e.g., zinc chloride), Zn cyanide, Zn hydroxide, Zn oxide, Zn peroxide, Zn carbonate, or a combination thereof. Examples of the zinc precursor may include dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, and the like.

In an embodiment, the selenium precursor may include selenium-trioctyl phosphine (Se-TOP), selenium-tributylphosphine (Se-TBP), selenium-triphenylphosphine (Se-TPP), or a combination thereof, but is not limited thereto.

In an embodiment, the sulfur precursor may include mercapto propyl silane, sulfur-trioctyl phosphine (S-TOP), sulfur-tributylphosphine (S-TBP), sulfur-triphenylphosphine (S-TPP), sulfur-trioctylamine (S-TOA), bis(trimethylsilyl) methyl sulfide, bis(trimethylsilyl)sulfide, ammonium sulfide, sodium sulfide, or a combination thereof.

In an embodiment, an amount of each of the precursors may be selected taking into account a desired composition of the final semiconductor nanoparticle, a reactivity of the precursor, a reaction temperature, or a reaction time.

An amount of the zinc precursor, per one mole of indium, is greater than or equal to 60 moles, for example greater than or equal to about 65 moles, greater than or equal to about 70 moles, greater than or equal to about 75 moles, greater than or equal to about 80 moles, or greater than or equal to about 85 moles. The amount of the zinc precursor may be, per one mole of indium, less than or equal to about 250 moles, less than or equal to about 200 moles, less than or equal to about 150 moles, less than or equal to about 100 moles, less than or equal to about 90 moles, or less than or equal to about 85 moles.

In an embodiment, an amount of the selenium precursor and an amount of sulfur precursor may be selected taking into account a desired composition of the final semiconductor nanoparticle.

In an embodiment, an amount of the selenium precursor may be, per one mole of indium precursor, greater than or equal to about 40 moles, greater than or equal to about 50 moles, greater than or equal to about 60 moles, greater than or equal to about 70 moles, greater than or equal to about 80 moles, or greater than or equal to about 90 moles. The amount of the selenium precursor may be, per one mole of indium, less than or equal to about 200 moles, less than or equal to about 170 moles, less than or equal to about 150 moles, less than or equal to about 130 moles, less than or equal to about 110 moles, less than or equal to about 90 moles, less than or equal to about 80 moles, less than or equal to about 70 moles, less than or equal to about 60 moles, or less than or equal to about 55 moles.

In an embodiment, an amount of the sulfur precursor may be, per one mole of indium precursor, greater than or equal to about 11 moles, greater than or equal to about 15 moles, greater than or equal to about 17 moles, greater than or equal to about 19 moles, greater than or equal to about 20 moles, greater than or equal to about 25 moles, or greater than or equal to about 30 moles. The amount of the sulfur precursor may be, per one mole of indium, less than or equal to about 40 moles, less than or equal to about 35 moles, less than or equal to about 20 moles, less than or equal to about 15 moles, or less than or equal to about 10 moles.

A mole ratio among the precursors may be controlled, taking into consideration the types of the precursors and the reaction conditions such as a reaction temperature and the reaction time, for the final semiconductor nanoparticle to have the mole ratios described herein.

The organic solvent may be a C6 to C22 primary amine such as hexadecylamine; a C6 to C22 secondary amine such as dioctylamine; a C6 to C40 tertiary amine such as trioctylamine; a nitrogen-containing heterocyclic compound such as pyridine; a C6 to C40 aliphatic hydrocarbon (e.g., alkane, alkene, or alkyne) such as hexadecane, octadecane, octadecene, or squalane; a C6 to C30 aromatic hydrocarbon such as phenyldodecane, phenyltetradecane, or phenyl hexadecane; a phosphine substituted with a C6 to C22 alkyl group such as trioctyl phosphine; a phosphine oxide substituted with a C6 to C22 alkyl group such as trioctyl phosphine oxide; a C12 to C22 aromatic ether such as phenyl ether, or benzyl ether, or a combination thereof.

The organic ligand may coordinate to a surface of the plurality of semiconductor nanoparticles thus prepared. The organic ligand may help the dispersibility of the nanostructures in an organic medium (e.g., an organic solution). The organic ligand may include RCOOH, $RNH_2$, $R_2NH$, $R_3N$, RSH, $RH_2PO$, $R_2HPO$, $R_3PO$, $RH_2P$, $R_2HP$, $R_3P$, ROH, RCOOR', $RPO(OH)_2$, RHPOOH, $R_2POOH$ (wherein, R and R' are each independently a C1 to C40 (or C3 to C24) aliphatic hydrocarbon group (e.g., alkyl group, alkenyl group, or alkynyl group), or C6 to C40 (or C6 to C24) aromatic hydrocarbon group (e.g., C6 to C20 aryl group)), or a combination thereof. The organic ligand may be used alone or as a mixture of two or more.

Examples of the organic ligand may include methane thiol, ethane thiol, propane thiol, butane thiol, pentane thiol, hexane thiol, octane thiol, dodecane thiol, hexadecane thiol, octadecane thiol, benzyl thiol; methane amine, ethane amine, propane amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; phosphine such as substituted or unsubstituted methyl phosphine (e.g., trimethyl phosphine, or methyldiphenyl phosphine), substituted or unsubstituted ethyl phosphine (e.g., triethyl phosphine, or ethyldiphenyl phosphine), substituted or unsubstituted propyl phosphine, substituted or unsubstituted butyl phosphine, substituted or unsubstituted pentyl phosphine, or substituted or unsubstituted octyl phosphine (e.g., trioctyl phosphine (TOP)); phosphine oxide such as substituted or unsubstituted methyl phosphine oxide (e.g., trimethyl phosphine oxide, or methyldiphenyl phosphine oxide), substituted or unsubstituted ethyl phosphine oxide (e.g., triethyl phosphine oxide, or ethyldiphenyl phosphine oxide), substituted or unsubstituted propyl phosphine oxide, substituted or unsubstituted butyl phosphine oxide, substituted or unsubstituted octyl phosphine oxide (e.g., trioctyl phosphine oxide (TOPO)); a diphenyl phosphine, a triphenyl phosphine compound, or an oxide compound thereof; phosphonic acid, a C5 to C20 alkylphosphinic acid such as hexylphosphinic acid, octylphosphinic acid, dodecanephosphinic acid, tetradecanephosphinic acid, hexadecanephosphinic acid, or octadecanephosphinic acid, or C5 to C20 alkyl phosphonic acid but is not limited thereto. In an embodiment, the organic ligand may include a combination of RCOOH and an amine (e.g., $RNH_2$, $R_2NH$, $R_3N$, or a combination thereof).

In an embodiment, reaction conditions such as a reaction time, or a reaction temperature may be selected appropriately taking into consideration a desired composition of the nanostructure.

After the reaction, a non-solvent may be added to reaction products and the plurality of semiconductor nanoparticles coordinated with, e.g., bound to, the ligand compound may be separated. The non-solvent may be a polar solvent that is miscible with the solvent used in the core formation reaction, shell formation reaction, or a combination thereof and is not capable of dispersing the produced nanocrystals therein. The non-solvent may be selected taking into consideration the solvent used in the reaction and may be for example acetone, ethanol, butanol, isopropanol, ethanediol, water, tetrahydrofuran (THF), dimethylsulfoxide (DMSO), diethyl ether, formaldehyde, acetaldehyde, a solvent having a similar solubility parameter to the foregoing non-solvents, or a combination thereof. Separation of the nanocrystal particles may involve centrifugation, sedimentation, chromatography, or distillation. The separated nanocrystal particles may be added to a washing (or dispersing) solvent and washed (or dispersed), if desired. Types of the washing (dispersing) solvent are not particularly limited and a solvent having similar solubility parameter to that of the ligand may be used and examples thereof may include hexane, heptane, octane, chloroform, toluene, or benzene.

In an embodiment, the light-emitting layer 3 or 30 may include a monolayer of quantum dots. In an embodiment, the light-emitting layer 3 or 30 may include a monolayer of quantum dots, e.g., one or more, two or more, three or more, or four or more and 20 or less, 10 or less, 9 or less, 8 or less, 7 or less, or 6 or less, monolayers of quantum dots. The light-emitting layer 3 or 30 may have a thickness of greater than or equal to about 5 nm, for example, greater than or equal to about 10 nm, greater than or equal to about 20 nm, or greater than or equal to about 30 nm and less than or equal to about 200 nm, for example, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light-emitting layer 3 or 30 may have the thickness of, for example about 10 nm to about 150 nm, for example about 20 nm to about 100 nm, or for example about 30 nm to about 50 nm.

In an embodiment, the light-emitting layer may include a first layer of first semiconductor nanoparticles (that are surface treated or ligand-exchanged) and a second layer of second semiconductor nanoparticles disposed on the first layer. The first semiconductor nanoparticle may be surface-treated with a halogen compound such as a zinc chloride or ligand-exchanged prior to or after the formation of the first layer and may have a surface ligand (e.g., a halogen such as Cl) different from the second semiconductor nanoparticles. Details of the first semiconductor nanoparticles and the second semiconductor nanoparticles are the same as for the description about the semiconductor nanoparticle.

In an embodiment, the electroluminescent device may include a charge auxiliary layer (e.g., an electron auxiliary layer, a hole auxiliary layer, or a combination thereof) between the first electrode and the second electrode.

The first electrode may be an anode, and a hole auxiliary layer 2 or 20 may be disposed between the first electrode 1 or 10 and the light-emitting layer 3 or 30. The hole auxiliary layer 2 or 20 may have a layer, e.g., one or more layers, and may include, for example, a hole injection layer, a hole transport layer, an electron blocking layer (not shown), or a combination thereof.

The HOMO energy level of the hole auxiliary layer 2 or 20 may be matched with the HOMO energy level of the light-emitting layer 3 or 30, so that the mobility of holes transferred from the hole auxiliary layer 2 or 20 to the light-emitting layer 3 or 30 may be enhanced. In an embodiment, the hole auxiliary layer 2 or 20 may include a hole injection layer proximate to the first electrode 1 or 10 and a hole transport layer proximate to the light-emitting layer 3 or 30.

The hole auxiliary layer may include an organic compound. The organic compound may have a HOMO energy level of greater than or equal to about 5.0 eV, greater than or equal to about 5.1 eV, greater than or equal to about 5.2 eV, greater than or equal to about 5.3 eV, or greater than or equal to about 5.4 eV. The organic compound may have a HOMO energy level of less than or equal to about 5.5 eV, less than or equal to about 5.4 eV, less than or equal to about 5.3 eV, less than or equal to about 5.2 eV, or less than or equal to about 5.1 eV.

A material of the hole auxiliary layer 2 or 20 (e.g., a hole transport layer or hole injection layer) is not particularly limited. In an embodiment, the material of the hole auxiliary layer may include poly(9,9-dioctyl-fluorene-co-N-(4-butylphenyl)-diphenylamine) (TFB), polyarylamine, poly(N-vinylcarbazole) (PVK), poly(3,4-ethylenedioxythiophene (PEDOT), poly(3,4-ethylenedioxythiophene)polystyrene sulfonate (PEDOT:PSS), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), 4,4',4"-Tris[phenyl(m-tolyl)amino]triphenylamine (m-MTDATA), 4,4',4"-tris(N-carbazolyl)-triphenylamine (TCTA), 1,1-bis[(di-4-tolylamino)phenyl]cyclohexane (TAPC), p-type metal oxide (e.g., NiO, $WO_3$, $MoO_3$, etc.), a carbon-based material such as graphene oxide, or a combination thereof, but is not limited thereto.

The electron blocking layer (EBL) may include, for example, poly(3,4-ethylenedioxythiophene):poly(styrene sulfonate) (PEDOT:PSS), poly(9,9-dioctyl-fluorene-co-N-(4-butylphenyl)-diphenylamine) (TFB), polyarylamine, poly(N-vinylcarbazole), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), m-MTDATA, 4,4',4"-tris(N-carbazolyl)-triphenylamine (TCTA), or a combination thereof, but is not limited thereto.

In the hole auxiliary layer(s), a thickness of each layer may be selected appropriately. In an embodiment, the thickness of each layer may be greater than or equal to about 5 nm, greater than or equal to about 10 nm, greater than or equal to about 15 nm, or greater than or equal to about 20 nm and less than or equal to about 50 nm, less than or equal to about 40 nm, less than or equal to about 50 nm, less than or equal to about 35 nm, or less than or equal to about 30 nm, but is not limited thereto.

In an embodiment, the second electrode may be a cathode, and the electron auxiliary layer 4 or 40 may be disposed between the light-emitting layer 3 or 30 and the second electrode 5 or 50. The electron auxiliary layer 4 or 40 may include, for example, an electron injecting layer, an electron transporting layer, a hole blocking layer, or a combination thereof. The electron auxiliary layer may be, for example, an electron injecting layer (EIL) that facilitates electron injection, an electron transporting layer (ETL) that facilitates electron transport, a hole blocking layer (HBL) that blocks hole movement, or a combination thereof. For example, an electron injecting layer may be disposed between the electron transport layer and the cathode. For example, a hole blocking layer may be disposed between the light-emitting layer and the electron transporting (injecting) layer, but is not limited thereto. The thickness of each layer may be appropriately selected. For example, the thickness of each layer may be greater than or equal to about 1 nm and less than or equal to about 500 nm, but is not limited thereto. The electron injecting layer may be an organic layer formed by deposition. The electron transporting layer may include inorganic oxide nanoparticles or be an organic layer formed by deposition.

The electron transporting layer (ETL) may include, for example, 1,4,5,8-naphthalene-tetracarboxylic dianhydride (NTCDA), bathocuproine (BCP), tris[3-(3-pyridyl)-mesityl]borane (3TPYMB), LiF, $Alq_3$, $Gaq_3$, $Inq_3$, $Znq_2$, $Zn(BTZ)_2$, $BeBq_2$, ET204 (8-(4-(4,6-di(naphthalen-2-yl)-1,3,5-triazin-2-yl)phenyl)quinolone), 8-hydroxyquinolinato lithium (Liq), n-type metal oxide (e.g., ZnO, or $HfO_2$), or a combination thereof, but is not limited thereto.

The hole blocking layer (HBL) may include, for example, 1,4,5,8-naphthalenetetracarboxylic dianhydride (NTCDA), bathocuproine (BCP), tris[3-(3-pyridyl)-mesityl]borane (3TPYMB), LiF, $Alq_3$, $Gaq_3$, $Inq_3$, Znq2, $Zn(BTZ)_2$, $BeBq_2$, or a combination thereof, but is not limited thereto.

The electronic auxiliary layer 4 or 40 may include a plurality of metal oxide nanoparticles. The nanoparticles may include a metal oxide including zinc. The metal oxide may include a zinc oxide, a zinc magnesium oxide, or a combination thereof. The metal oxide may include $Zn_{1-x}M_xO$ (wherein, M is Mg, Ca, Zr, W, Li, Ti, Y, Al, Co, or a combination thereof, and $0 \leq x \leq 0.5$). In an embodiment, M may be magnesium (Mg). In an embodiment, x may be greater than or equal to about 0.01 and less than or equal to about 0.3, for example, less than or equal to about 0.25, less than or equal to about 0.2, or less than or equal to about 0.15. In an embodiment, the metal oxide (e.g., zinc oxide, zinc magnesium oxide, or a combination thereof) nanoparticles may further include an alkali-metal (e.g., cesium, rubidium, lithium, potassium, or a combination thereof).

In an embodiment, an absolute value of LUMO of the aforementioned semiconductor nanoparticle included in the light-emitting layer may be less than an absolute value of LUMO of the metal oxide. The semiconductor nanoparticles may have an average size of greater than or equal to about 1 nm, for example, greater than or equal to about 1.5 nm, greater than or equal to about 2 nm, greater than or equal to about 2.5 nm, or greater than or equal to about 3 nm and less than or equal to about 10 nm, less than or equal to about 9 nm, less than or equal to about 8 nm, less than or equal to about 7 nm, less than or equal to about 6 nm, or less than or equal to about 5 nm. In an embodiment, the nanoparticles may not be rod-shaped or a nanowire.

In an embodiment, each thickness of the electron auxiliary layer 4 or 40 (e.g., an electron injecting layer, an electron transporting layer, or a hole blocking layer) may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

A device according to an embodiment may have a normal structure. In an embodiment, referring to FIG. 2, the device includes a first electrode 10 disposed on a transparent substrate 100, e.g., a metal oxide-based (i.e., metal oxide) transparent electrode (e.g., ITO electrode) and a second electrode 50 (e.g., facing the first electrode) may include a conductive metal (e.g., Mg, or Al) (e.g., having a relatively low work function). A hole auxiliary layer 20 (e.g., a hole injecting layer of, for example, PEDOT:PSS, p-type metal oxide, or a combination thereof; a hole transport layer of TFB, PVK, or a combination thereof; or a combination thereof) may be disposed between the transparent electrode 10 and the light-emitting layer 30. The hole injecting layer may be proximate to the transparent electrode and the hole transport layer may be proximate to the light-emitting layer. An electron auxiliary layer 40 such as an electron injecting layer/transporting layer may be disposed between the quantum dot light-emitting layer 30 and the second electrode 50.

In an embodiment, a device may have an inverted structure. For example, referring to FIG. 3, a second electrode 50 is disposed on a transparent substrate 100, e.g., a metal oxide-based transparent electrode (e.g., ITO) and a first electrode 10 may include a metal (e.g., Au, or Ag) (e.g., having a relatively high work function). For example, (optionally doped) n-type metal oxide (crystalline Zn metal oxide) may be disposed between the transparent electrode 50 and the light-emitting layer 30 as an electron auxiliary layer 40 (e.g., an electron transporting layer). A hole auxiliary layer 20 (e.g., a hole transport layer including TFB, PVK, or a combination thereof; a hole injecting layer including $MoO_3$ or other p-type metal oxides; or a combination thereof) may be disposed between the first electrode 10 and the quantum dot light-emitting layer 30.

The electroluminescent device of an embodiment may be prepared in an appropriate method. In an embodiment, the electroluminescent device may be prepared by providing a first (or second) electrical conductor, optionally forming a charge auxiliary layer thereon for example by depositing or coating, and forming a light-emitting layer including the aforementioned plurality of semiconductor nanoparticles (e.g., a pattern thereof), optionally provide a charge auxiliary layer, and providing a second (or a first) electrical conductor for example via deposition or coating.

The formation of the electrical conductor layer and the charge auxiliary layer (e.g., the hole auxiliary layer or the electron auxiliary layer) may be carried out appropriately and are not particularly limited.

It is appropriately selected considering a kind of the forming material, or a thickness of the electrode/layer to be fabricated. The forming method may include a solution (wet) process, a deposition, or a combination thereof. For example, the hole auxiliary layer 2 or 20, the light-emitting layer 3 or 30, and the electron auxiliary layer 4 or 40 may be obtained by, for example, a solution process. The solution process may include, for example, a spin coating, a slit coating, an inkjet printing, a nozzle printing, a spraying, a doctor blade coating, or a combination thereof, but is not limited thereto.

In an embodiment, when the electron auxiliary layer includes an inorganic material, the electron auxiliary layer may be formed by performing a wet process. In an embodiment, the wet process may include a sol-gel method. In an embodiment, the wet process may include coating a dispersion in which nanoparticles are dispersed in a polar solvent on the light-emitting layer (e.g., by a spin coating); and drying and annealing the same. The polar solvent may include a C1 to C10 alcohol solvent such as ethanol, a C2 to C20 sulfoxide solvent such as dimethylsulfoxide, a C2 to C20 amide solvent such as dimethyl formamide, or a combination thereof, but is not limited thereto. The annealing may be performed at a predetermined temperature (e.g., a temperature of greater than or equal to about 60 °C, or greater than or equal to about 70 °C and less than or equal to about 100 °C, for example, less than or equal to about 90 °C, less than or equal to about 80 °C, or less than or equal to about 75 °C), for example, under vacuum, but is not limited thereto.

The forming of the light-emitting layer 3 or 30 including the nanostructures may include obtaining a composition including the nanostructures and coating or depositing the composition on a substrate or a charge auxiliary layer by an appropriate method (e.g., by spin coating, or inkjet printing). The applied or deposited light-emitting layer may be heat-treated for drying. The heat-treating temperature is not particularly limited, and may be appropriately selected in consideration of a boiling point of the organic solvent used for preparing the dispersion. For example, the heat-treating temperature may be greater than or equal to about 60 °C, for example, greater than or equal to about 70 °C. The organic solvent for the dispersion including the nanostructures is not particularly limited and thus may be appropriately selected. In an embodiment, the organic solvent may include a (substituted or unsubstituted) aliphatic hydrocarbon organic solvent, a (substituted or unsubstituted) aromatic hydrocarbon organic solvent, an acetate solvent, or a combination thereof.

In an embodiment, the electroluminescent device may exhibit improved luminous properties (e.g., improved electroluminescent properties) or a combination thereof.

In an embodiment, the electroluminescent device may exhibit a maximum external quantum efficiency (max EQE) of greater than or equal to about 9%, greater than or equal to about 9.5%, greater than or equal to 10%, greater than or equal to about 10.2%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, greater than or equal to about 14%, greater than or equal to about 15%, greater than or equal to about 15.5%, greater than or equal to about 16%, greater than or equal to about 16.5%, or greater than or equal to about 17%. In an aspect, the electroluminescent device may exhibit a maximum EQE of in a range from about 9% to about 60%, from about 10% to about 55%, from about 15% to about 45%, or a combination thereof.

In an embodiment, the electroluminescent device may exhibit a maximum luminance (max luminance) of greater than or equal to 300,000 candelas per square meter ($cd/m^2$), greater than or equal to about 310,000 $cd/m^2$, greater than or equal to about 320,000 $cd/m^2$, greater than or equal to about 330,000 $cd/m^2$, greater than or equal to about 340,000 $cd/m^2$, or greater than or equal to about 350,000 $cd/m^2$. In an aspect, the electroluminescent device may exhibit a maximum luminance of less than or equal to about 650,000 $cd/m^2$, less than or equal to about 630,000 $cd/m^2$, or less than or equal to about 600,000 $cd/m^2$.

The electroluminescent device may exhibit the aforementioned max EQE and the aforementioned max luminance.

The electroluminescent device may exhibit relatively improved lifespan properties. In an embodiment, when being operated at a predetermined initial luminance, e.g., of greater than or equal to about 650 nit (candelas per square meter, $cd/m^2$), greater than or equal to 1000 nit, greater than or equal to about 2000 nit, or 2700 nit, the electroluminescent device may have a T90 of greater than or equal to about 100 hours, greater than or equal to about 150 hours, greater than or equal to about 200 hours, greater than or equal to about 250 hours, greater than or equal to about 300 hours, greater than or equal to about 350 hours, greater than or equal to about 400 hours, greater than or equal to about 450 hours, greater than or equal to 500 hours, greater than or equal to about 550 hours, greater than or equal to about 600 hours, greater than or equal to about 650 hours, greater than or equal to about 700 hours, greater than or equal to about 750 hours, greater than or equal to about 800 hours, greater than or equal to about 850 hours, greater than or equal to about 900 hours, greater than or equal to about 950 hours, greater than or equal to about 1000 hours, greater than or equal to about 1050 hours, greater than or equal to about 1100 hours, greater than or equal to about 1150 hours, or greater than or equal to about 1200 hours. In an aspect, the electroluminescent device may have a T90 of from about 100 hours to about 10,000 hours, from about 500 hours to about 4500 hours, from about 600 hours to about 4000 hours, from about 700 hours to about 3500 hours, from about 800 hours to about 3000 hours, or a combination thereof.

The predetermined initial luminance may be 2700 nit. As the predetermined initial luminance increases, the lifespan of the electroluminescent device (e.g., the T90) may decrease. Therefore, the T90 at the operation of the initial luminance of 1000 nit may be calculated by multiplying the T90 at the operation of the initial luminance of 2700 nit with a correction factor, about 7.3 times.

In an embodiment, a display device including the electroluminescent device described herein.

The display device may include a first pixel and a second pixel that is configured to emit light different from the first pixel. The first pixel, the second pixel, or a combination thereof, may include the electroluminescent device of an embodiment. In an embodiment, the red pixel may include a red light-emitting layer including a plurality of red light-emitting semiconductor nanoparticles, the green pixel may include a green light-emitting layer including a plurality of green light-emitting semiconductor nanoparticles, and the blue pixel may include a blue light-emitting layer including a plurality of blue light-emitting semiconductor nanoparticles.

In an embodiment, a light emitting device may include a light emitting layer including the semiconductor nanoparticle described herein; and a light source, wherein the light source is configured to provide the light emitting layer with an incident light. The light emitting device may be included in a display device. In the light emitting layer, the semiconductor nanoparticle may be dispersed in a matrix (e.g., a polymer matrix).

The device (display device or light emitting device) may further include a luminescent element, e.g., light emitting element, and optionally a light source. The luminescent element may include a light emitting layer. The luminescent element may further include a substrate, and the light emitting layer may be disposed on one surface of the substrate. The light emitting layer may include a film or patterned film of the quantum dot composite. The light source may be configured to provide incident light to the luminescent element. The incident light may have a photoluminescence peak wavelength in a range of greater than or equal to about 440 nm, for example, greater than or equal to about 450 nm and less than or equal to about 500 nm, for example, less than or equal to about 480 nm, less than or equal to about 470 nm, or less than or equal to about 460 nm.

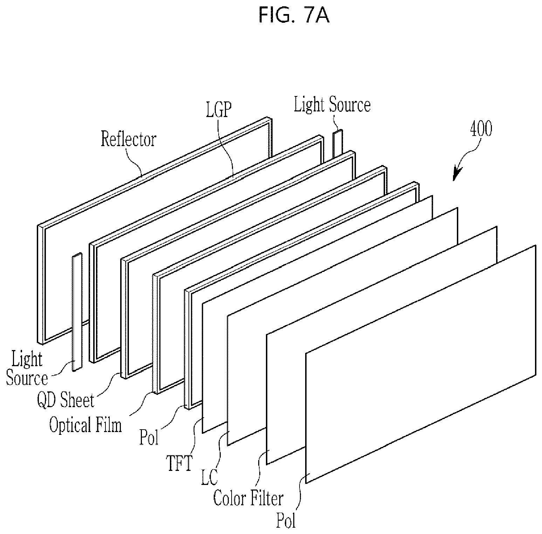

In an embodiment, the luminescent element or the light emitting layer may include a sheet of the quantum dot composite. Referring to FIG. 7A, a photoluminescence type device 400 includes a backlight unit and a liquid crystal panel, and the backlight unit may include a quantum dot polymer composite sheet (QD sheet). For example, the backlight unit may include a reflector, a light guide plate (LGP), a light source (blue LED, etc.), a quantum dot polymer composite sheet (QD sheet), and optical films (prism, dual brightness enhancement film (DBEF), etc.) and the like). The liquid crystal panel may be disposed on the backlight unit and may have a structure including a thin film transistor (TFT), liquid crystal (LC), and a color filter between two polarizers (Pol). The quantum dot polymer composite sheet (QD sheet) may include quantum dots emitting red light and quantum dots emitting green light by absorbing light from a light source. Blue light from the light source may pass through the quantum dot polymer composite sheet, being combined with red light and green light emitted from quantum dots and converted to white light. The white light may be separated to blue light, green light, and red light by a color filter in the liquid crystal panel and may be emitted to the outside in each pixel.

In an embodiment, the light emitting layer may be disposed on a front surface (e.g., a light extraction surface) of a device (light emitting device or display device) in a form of a quantum dot (or a composite thereof) patterned film. The patterned film may include a repeating section configured to emit a desired light. The repeating section may include a first section. The first section may be a red light emitting section. The repeating section may include a second section. The second section may include a green light emitting section. The repeating section may include a third section. The third section may be a section that emits or transmits blue light.

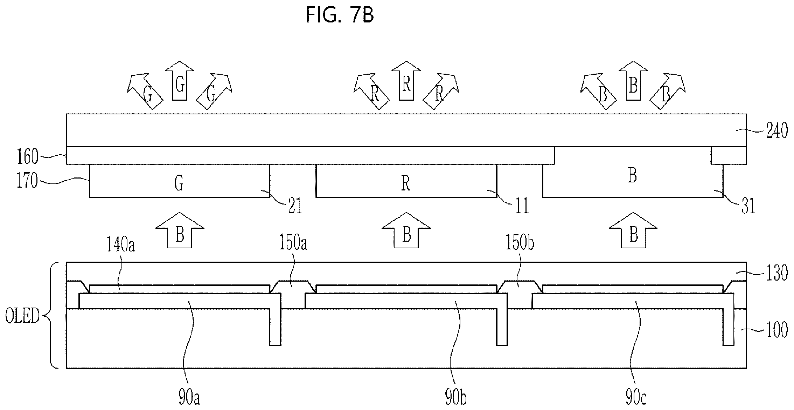

FIG. 7B is a schematic cross-sectional view of a display device according to an embodiment. Referring to FIG. 7B, the light source includes an organic light emitting diode (OLED) that emits blue (B) light (and optionally green light). The organic light emitting diode (OLED) may include at least two pixel electrodes 90a, 90b, 90c formed on the substrate 100, a pixel define layer 150a, 150b formed between the adjacent pixel electrodes 90a, 90b, 90c, an organic light emitting layer 140a, 140b, 140c formed on each pixel electrode 90a, 90b, 90c, and a common electrode layer 130 formed on the organic light emitting layer 140a, 140b, 140c. A thin film transistor and a substrate may be disposed under the organic light emitting diode (OLED). A laminated structure including the quantum dot composite pattern 170 (e.g., a first section 11 or R including red light emitting quantum dots, a second section 21 or G including green light emitting quantum dots, and a third section 31 or B including or not including a quantum dot, e.g., a blue light emitting quantum dot) pattern and substrate 240 may be disposed on the light source. The blue light emitted from the light source enters the first section and second section and may emit red light and green light, respectively. The blue light emitted from the light source may pass through the third section. An element (first optical filter 160 or excitation light blocking layer) configured to block the excitation light may be disposed between the quantum dot composite layers R and G and the substrate, as desired. When the excitation light includes blue light and green light, a green light blocking filter may be added to the third section.

The substrate may be a substrate including an insulation material. Details of the substrate are the same as set forth herein.

A wire layer including a thin film transistor or the like is formed on the substrate. The wire layer may further include a gate line, a sustain voltage line, a gate insulating layer, a data line, a source electrode, a drain electrode, a semiconductor, a protective layer, and the like. The detailed structure of the wire layer may vary depending on an embodiment. The gate line and the sustain voltage line are electrically separated from each other, and the data line is insulated and crossing the gate line and the sustain voltage line. The gate electrode, the source electrode, and the drain electrode form a control terminal, an input terminal, and an output terminal of the thin film transistor, respectively. The drain electrode is electrically connected to the pixel electrode that will be described herein.

The pixel electrode may function as an electrode (e.g., anode) of the display device. The pixel electrode may be formed of a transparent conductive material such as indium tin oxide (ITO) or indium zinc oxide (IZO). The pixel electrode may be formed of a material having a light-blocking properties such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure in which the transparent conductive material and the material having light-blocking properties are laminated sequentially.

Between two adjacent pixel electrodes, a pixel define layer (PDL) overlapped with a terminal end of the pixel electrode to divide the pixel electrode into a pixel unit. The pixel define layer is an insulation layer which may electrically block the at least two pixel electrodes.

The pixel define layer covers a portion of the upper surface of the pixel electrode, and the remaining region of the pixel electrode not covered by the pixel define layer may provide an opening. An organic light emitting layer that will be described herein may be formed in the region defined by the opening.

The organic light emitting layer defines each pixel area by the aforementioned pixel electrode and the pixel define layer. In other words, one pixel area may be defined as an area formed with one organic light emitting unit layer which is contacted with one pixel electrode divided by the pixel define layer. In the display device according to an embodiment, the organic light emitting layer may be defined as a first pixel area, a second pixel area and a third pixel area, and each pixel area is spaced apart from each other leaving a predetermined interval by the pixel define layer.

In an embodiment, the organic light emitting layer may emit a third light belonging to a visible light region or belonging to an ultraviolet (UV) region. Each of the first to the third pixel areas of the organic light emitting layer may emit third light. In an embodiment, the third light may be a light having the highest energy in the visible light region, for example, may be blue light (and optionally green light). When all pixel areas of the organic light emitting layer are designed to emit the same light, each pixel area of the organic light emitting layer may be all formed of the same or similar materials or may show, e.g., exhibit, the same or similar properties. Thus a process of forming the organic light emitting layer may be simplified, and the display device may be easily applied for, e.g., made by, a large scale/large area process. However, the organic light emitting layer according to an embodiment is not necessarily limited thereto, but the organic light emitting layer may be designed to emit at least two different lights, e.g., at least two different colored lights.

The organic light emitting layer includes an organic light emitting unit layer in each pixel area, and each organic light emitting unit layer may further include an auxiliary layer (e.g., hole injection layer, hole transport layer, electron transport layer, etc.) besides the light emitting layer.

The common electrode may function as a cathode of the display device. The common electrode may be formed of a transparent conductive material such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include a (e.g., transparent) insulating material for ensuring electrical insulation with the common electrode.

In an embodiment, the display device may further include a lower substrate, a polarizing plate disposed under the lower substrate, and a liquid crystal layer disposed between the laminated structure and the lower substrate, and in the laminated structure, the photoluminescence layer (i.e., light emitting layer) may be disposed to face the liquid crystal layer. The display device may further include a polarizing plate between the liquid crystal layer and the light emitting layer. The light source may further include LED and if desired, a light guide plate.

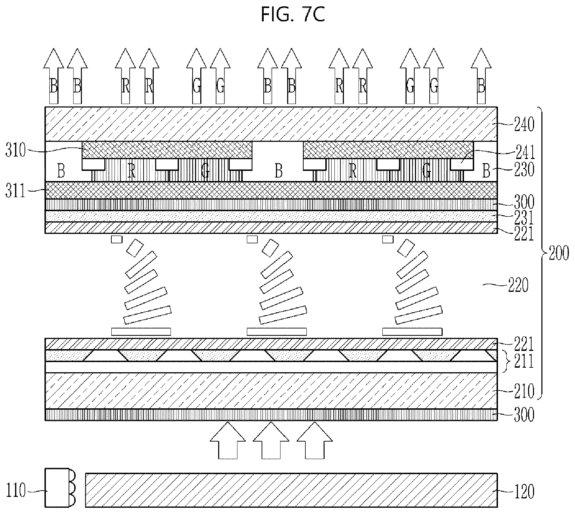

Non-limiting examples of the display device (e.g., a liquid crystal display device) according to an embodiment are illustrated with a reference to a drawing. FIG. 7C is a schematic cross-sectional view showing a liquid crystal display according to an embodiment. Referring to FIG. 7C, the display device of an embodiment includes a liquid crystal panel 200, a polarizing plate 300 disposed under the liquid crystal panel 200, and a backlight unit disposed under the polarizing plate 300.

The liquid crystal panel 200 includes a lower substrate 210, a stack structure, and a liquid crystal layer 220 disposed between the stack structure and the lower substrate. The stack structure includes a transparent substrate 240, a first optical filter layer 310, a photoluminescent layer 230 including a pattern of a quantum dot polymer composite, and a second optical filter layer 311.

The lower substrate 210 referred to as an array substrate may be a transparent insulation material substrate. The substrate is the same as described herein. A wire plate 211 is provided on an upper surface of the lower substrate 210. The wire plate 211 may include a plurality of gate wires (not shown) and data wires (not shown) that define a pixel area, a thin film transistor disposed adjacent to a crossing region of gate wires and data wires, and a pixel electrode for each pixel area, but is not limited thereto. Details of such a wire plate are not particularly limited.

The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal layer and the alignment layer are not particularly limited.

A lower polarizing plate 300 is provided under the lower substrate 210. Materials and structures of the polarizing plate 300 are not particularly limited. A backlight unit (e.g., emitting blue light) may be disposed under the polarizing plate 300. An upper optical element or the polarizing plate 300 may be provided between the liquid crystal layer 220 and the transparent substrate 240, but is not limited thereto. For example, the upper polarizing plate may be disposed between the liquid crystal layer 220 and the photoluminescent layer 230. The polarizing plate may be any suitable polarizer that used in a liquid crystal display device. The polarizing plate may be TAC (triacetyl cellulose) having a thickness of less than or equal to about 200 $\mu$m, but is not limited thereto. In an embodiment, the upper optical element may be a coating that controls a refractive index without a polarization function.

The backlight unit includes a light source 110. The light source 110 may emit blue light or white light. The light source 110 may include a blue LED, a white LED, a white OLED, or a combination thereof, but is not limited thereto.

The backlight unit may further include a light guide plate 120. In an embodiment, the backlight unit may be an edge-type lighting. For example, the backlight unit may include a reflector (not shown), a light guide plate (not shown) provided on the reflector and providing a planar light source to the liquid crystal panel 200, a, e.g., at least one, optical sheet (not shown) on the light guide plate, for example, a diffusion plate, a prism sheet, and the like, or a combination thereof, but is not limited thereto. The backlight unit may not include a light guide plate. In an embodiment, the backlight unit may be a direct lighting. For example, the backlight unit may have a reflector (not shown), and may have a plurality of fluorescent lamps disposed on the reflector at regular intervals, or may have an LED operating substrate on which a plurality of light emitting diodes may be disposed, a diffusion plate thereon, and optionally a, e.g., at least one, optical sheet. Details (e.g.,

each component of a light emitting diode, a fluorescent lamp, a light guide plate, various optical sheets, and a reflector) of such a backlight unit are not particularly limited.

A black matrix 241 is provided under the transparent substrate 240 and has openings and hides a gate line, a data line, and a thin film transistor of the wire plate on the lower substrate. For example, the black matrix 241 may have a lattice shape. The photoluminescent layer 230 is provided in the openings of the black matrix 241 and has a quantum dot composite pattern including a first section (R) configured to emit first light (e.g., red light), a second section (G) configured to emit second light (e.g., green light), and a third section (B) configured to emit/transmit, for example blue light. If desired, the photoluminescent layer 230 may further include a, e.g., at least one, fourth section. The fourth section may include a quantum dot that emits a light of different color from light emitted from the first to third sections (e.g., cyan, magenta, and yellow light).

In the photoluminescent layer 230, sections forming the pattern may be repeated corresponding to pixel areas formed on the lower substrate 210. A transparent common electrode 231 may be provided on the photoluminescent type color filter layer.

The third section (B) configured to emit/transmit blue light may be a transparent color filter that does not change an emission spectrum of the light source. Blue light emitted from the backlight unit may enter in a polarized state and may be emitted through the polarizing plate and the liquid crystal layer as is. If desired, the third section may include a quantum dot emitting blue light.

As described herein, if desired, the display device or light emitting device of an embodiment may further have an excitation light blocking layer or a first optical filter layer (hereinafter referred to as a first optical filter layer). The first optical filter layer may be disposed between the bottom surface of the first section (R) and the second section (G) and the substrate (e.g., the upper substrate 240) or on the upper surface of the substrate. The first optical filter layer 310 may be a sheet having an opening in a region corresponding to a pixel area (a third section) displaying blue and thus formed in a region corresponding first and second sections. The first optical filter layer may be disposed at the positions except the position overlapped with the third section and integrally therewith as shown in FIGS. 7B, and FIG. 7C, but is not limited thereto. For example, at least two first optical filter layers may be disposed leaving a space at each position overlapped with the first and second sections. When the light source includes a green light emitting element, a green light blocking layer may be disposed on the third section.

The first optical filter layer may block (e.g., absorb) or substantially block light having, for example, a predetermined wavelength region in the visible light region and may transmit light in the other wavelength regions, and for example, the first optical filter layer may block blue light (or green light) and may transmit light except the blue light (or green light). The first optical filter layer may transmit, for example, green light, red light, and/or yellow light which is a mixed color thereof.

The first optical filter layer may substantially block excitation light and transmit light in a desired wavelength range. The transmittance of the first optical filter layer for the light in a desired wavelength range may be greater than or equal to about 70%, greater than or equal to about 80%, greater than or equal to about 90%, or even about 100%.

The first optical filter layer configured to selectively transmit red light may be disposed at a position overlapped with the red light emission section, and the first optical filter layer configured to selectively transmit green light may be disposed at a position overlapped with the green light emission section. The first optical filter layer may include a first region that blocks (e.g., absorb) blue light and red light and selectively transmits light of a predetermined range (e.g., greater than or equal to about 500 nm, greater than or equal to about 510 nm, or greater than or equal to about 515 nm and less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm); a second region that blocks (e.g., absorb) blue light and green light and selectively transmits light of a predetermined range (e.g., greater than or equal to about 600 nm, greater than or equal to about 610 nm, or greater than or equal to about 615 nm and less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm); or a combination thereof. When the light source emits blue and green mixed light, the first optical filter may further include a third region that selectively transmits blue light and blocks green light.

The first region may be disposed at a position overlapped with the green light emitting section. The second region may be disposed at a position overlapped with the red light emitting section. The third region may be disposed at a position overlapped with the blue light emitting section.

The first region, the second region, and, optionally, the third region may be optically isolated. Such a first optical filter layer may contribute to improvement of color purity of the display device.

The display device may further include a second optical filter layer (e.g., a red/green or yellow light recycle layer) 311 disposed between the photoluminescent layer and the liquid crystal layer (e.g., the photoluminescent layer and the upper polarizing plate, e.g., polarizer), transmitting at least a portion of third light (excitation light), and reflecting a, e.g., at least one, part of the first light, part of the second light, or part of each of the first light and second light. The first light may be red light, the second light may be green light, and the third light may be blue light. For example, the second optical filter layer may transmit only the third light (B) in a blue light wavelength region having a wavelength region of less than or equal to about 500 nm and light in a wavelength region of greater than about 500 nm, which is green light (G), yellow light, red light (R), or the like, may be not passed through the second optical filter layer and reflected. The reflected green light and red light may pass through the first and second sections and to be emitted to the outside of the display device.

The second optical filter layer or the first optical filter layer may be formed as an integrated layer having a relatively planar surface.

The first optical filter layer may include a polymer thin film including a dye absorbing light in a wavelength which is to be blocked, a pigment absorbing light in a wavelength which is to be blocked, or a combination thereof. The second optical filter layer and the first optical filter layer may include a single layer having a low refractive index, and may be, for example, a transparent thin film having a refractive index of less than or equal to about 1.4, less than or equal to about 1.3, or less than or equal to about 1.2. The second optical filter layer or the first optical filter layer having a low refractive index may be, for example, a porous silicon oxide, a porous organic material, a porous organic/inorganic composite, or a combination thereof.

The first optical filter layer or the second optical filter layer may include a plurality of layers having different refractive indexes. The first optical filter layer or the second optical filter layer may be formed by laminating two layers having different refractive indexes. For example, the first/second optical filter layer may be formed by alternately laminating a material having a high refractive index and a material having a low refractive index.

The display device or an electronic device may include (or may be) a handheld terminal, a monitor, a notebook computer, a television, an electronic display board, a camera, or a part for an automatic, e.g., autonomous, vehicle.

Hereinafter, specific embodiments of the present invention are presented. However, the examples described below are only for specifically illustrating or explaining the invention, and thus the scope of the invention should not be limited.

Examples

Analysis Method

1. Ultraviolet-visible (UV-vis) Spectroscopy Analysis
UV-vis absorption spectrum is obtained by using any commercially available spectrophotometer (e.g., an Agilent Cary 5000 spectrophotometer. U-3010 Spectrophotometer from Hitachi Co. Ltd., or UV-2600i from Shimadzu Co. Ltd.)

2. Photoluminescence Analysis and Absolute Quantum Yield (QY) measurement

(1) Photoluminescence (PL) spectra of the produced nanocrystals are measured at room temperature using a Hitachi F-7000 spectrophotometer and an irradiation wavelength of 458 nanometers (nm).
(2) An absolute quantum yield can be measured using a Quantaurus-QY measurement equipment (Quantaurus-QY Absolute PL quantum yield spectrophotometer C11347-11) from Hamamatsu Co., Ltd, a multi-channel detector according to the instruction manual of the manufacturer.

3. Transmission Electron Microscopy (TEM) Analysis
TEM-Titan G2 is used.

4. Decay Associated Spectrum (DAS) analysis
A DAS analysis is carried out as below:
A test sample of semiconductor nanoparticles (for example, quantum dot, QD) in a form of a QD solution or a QD film is prepared.
A laser beam of about 395 nm generated from a circularly polarized picosecond-pulsed excitation laser (LDH-D-C-390, Picoquant) is irradiated to the QD solution or film sample. The generated photon passes a dual-port monochromator (Kymera 193i-B, Andor), and using a charge coupled device (iVac 316, Andor) and photon counting detector (Pma hybrid 40, Picoquant), the DAS analysis is conducted. A comparison is made for the QD solution or the QD film between the initial photoluminescent (PL) spectrum and the PL spectrum after a predetermined time (e.g., 20 nanoseconds) to obtain a wavelength difference.

5. Inductively Coupled Plasma (ICP) Analysis
An inductively coupled plasma-atomic emission spectroscopy (ICP-AES) analysis is performed using Shimadzu ICPS-8100.

6. An X-ray photoelectron spectroscopy (XPS) analysis

An XPS analysis is conducted using an XPS instrument (manufacturer: Physical Electronics, model name: Quantum2000).

7. Electroluminescence measurement

Electroluminescent properties of the obtained semiconductor nanoparticle light-emitting device are evaluated using a Keithley 2200 source measuring device and a Minolta CS2000 spectroradiometer (a current-voltage-luminance measurement equipment). A current depending on a voltage applied to the devices, luminance, and electroluminescence (EL) are measured by using the current-voltage-luminance-measuring equipment, and the external quantum efficiency is calculated.

8. Lifespan evaluation

T50(h): A device is started to be driven at a predetermined brightness (e.g., 2700 nit (candelas per square meter)), and the time (hours (hr)) for the brightness to decrease to 50% of the initial brightness (100%) is determined.
T90(h): A device is started to be driven at a predetermined brightness (e.g., 2700 nit (candelas per square meter)), and the time (hours (hr)) for the brightness to decrease to 90% of the initial brightness (100%) is determined.

The following synthesis is performed under an inert gas atmosphere (e.g., under nitrogen) unless otherwise specified. A precursor content is provided as a molar content, unless otherwise specified.

Reference Example 1:

Indium acetate, zinc acetate, and palmitic acid are dissolved in 1-octadecene in a 200 milliliter (mL) reaction flask and then heated at 120 °C under vacuum.
A mole ratio among the indium and the zinc is 1:1.
After 1 hour, an atmosphere of the reaction flask is changed to nitrogen. After a temperature in the reaction flask is increased to 280 °C, a mixed solution of tris(trimethylsilyl)phosphine (($TMS)_3P$) and trioctyl phosphine is rapidly injected into the reaction flask, and the reaction is allowed to continue to obtain a desired first absorption wavelength in an ultraviolet-visible (UV-Vis) absorption spectrum. Then, the reaction solution is rapidly cooled to room temperature. Acetone is added to facilitate formation of a precipitate, the precipitate is separated with a centrifuge, and the isolated precipitate is dispersed in toluene to prepare a toluene dispersion.
$(TMS)_3P$ is used in an amount of 0.75 mole per one mole of indium. The first semiconductor nanocrystal thus obtained shows a first absorption wavelength of about 430 nm in an ultraviolet-visible (UV-Vis) absorption spectrum, having an average particle size of about 2.1 nm.

Reference Example 2: Synthesis of ZnMgO Nanoparticles

Zinc acetate dihydrate and magnesium acetate tetrahydrate are added to a reactor containing dimethyl sulfoxide and heated to 60 °C under air. An ethanol solution of tetramethylammonium hydroxide pentahydrate is then added to the reactor. After 1 hour of stirring, a precipitate forms that is then separated with a centrifuge and dispersed in ethanol, obtaining $Zn_{1-x}Mg_xO$ nanoparticles. (x = 0.15)
A transmission electron microscope analysis of the nanoparticles confirms that the particles have an average size of about 3 nm.

Preparation Example 1:

Selenium is dispersed in trioctyl phosphine to prepare a Se/TOP stock solution, and sulfur is dispersed in trioctyl phosphine to prepare a S/TOP stock solution.
Zinc acetate and oleic acid are dissolved in trioctylamine in a 0.2 Liter (L) reaction flask, and the solution is vacuum-treated at 120 °C for 10 minutes. The reaction flask is filled with nitrogen ($N_2$) and the zinc solution is heated to 340 °C, during which the toluene dispersion of the first semiconductor nanocrystal (first absorption wavelength: 430 nm) prepared in Reference Example is added to the reaction flask, and the Se/TOP stock solution is intermittently injected four times into the reaction flask and a reaction is carried out for 100 minutes to form a particle including a zinc selenide semiconductor nanocrystal on the first semiconductor nanocrystal, provided that directly after a first injection of the selenium precursor, an additive (e.g., dodecane thiol, a sodium oleate, or both) is injected. During the injection of the selenium precursor, if desired, the zinc oleate is further added to the reaction flask.
Then, an intermediate separation is conducted wherein a temperature of the reaction flask is cooled and ethanol is added to facilitate the precipitation of nanoparticles, which is then centrifuged and re-dispersed in toluene to obtain a particle dispersion.

The zinc solution is prepared again in the same manner as above and is heated again to the reaction temperature, and the particle dispersion thus obtained and the S/TOP stock solution are injected into the reaction flask and a reaction is carried out for 50 minutes to obtain a semiconductor nanoparticle having a zinc sulfide semiconductor nanocrystal thereon.

The reaction flask is cooled to room temperature and ethanol is added to facilitate formation of the semiconductor nanoparticles, which are then separated with a centrifuge. After the centrifugation, the supernatant is discarded and the precipitate is dried and then dispersed in octane.

In a reaction system, the used amount of the zinc precursor per one mole of indium is about 125 moles. A mole ratio of the selenium precursor and the sulfur precursor is about 2:1. A sum of the used amounts of the selenium precursors and the sulfur precursors is about 0.5 mole, per one mole of the zinc precursor.

The used amount of the additive (e.g., dodecane thiol or sodium oleate) is about 1 mole or 2 moles per 100 moles of the selenium precursor.

During the injection of the selenium precursor, a mole ratio among a first aliquot, a second aliquot, the third aliquot; and the fourth aliquot is about 1:1.5:2:2.5.

An ICP-AES of the obtained semiconductor nanoparticles is analyzed, and the result data is listed in Table 1. A TEM analysis, a UV-Vis absorption spectroscopy analysis, and a photoluminescent analysis are carried out and the results are shown in Table 2 and Table 3.

In the prepared semiconductor nanoparticle, a thickness of the semiconductor nanocrystal including a zinc selenide (e.g., an inner layer of the shell) is about 2.8 nm.

Average values of circularity and roundness of the prepared semiconductor nanoparticle is about 0.86 and 0.89, respectively.

Experimental Example 1

During the same synthesis as in Example 1, an aliquot (hereinafter, particle 1) is sampled out from the reaction system 1 minute after the additive is added and for the aliquot, an XPS analysis is conducted.

As a control experiment, during the same synthesis as in Example 1 except for not using the additive, an aliquot (hereinafter, particle 2) is sampled out from the reaction system 1 minute after the selenium precursor is first injected.

For particle 1 and particle 2, an XPS analysis is carried out and the results confirm that an intensity ratio of PO4 with respect to InZnP for particle 1 is less than one third (1/3) of an intensity ratio of PO4 with respect to InZnP for particle 2. Such a result indicates that the synthesis at the presence of the additive can significantly suppress the formation of the phosphorus oxide.

Preparation Example 2

The semiconductor nanoparticle is prepared in the same manner as set forth in Preparation Example 1, except that the amount of the selenium precursor is increased by 50% and the reaction time for forming the zinc selenide semiconductor nanocrystal is also increased by 10 minutes.

An ICP-AES of the obtained semiconductor nanoparticles is analyzed, and the result data is listed in Table 1. A TEM analysis, a UV-Vis absorption spectroscopy analysis, and a photoluminescent analysis are carried out and the results are shown in Table 2 and Table 3.

In the prepared semiconductor nanoparticle, a thickness of the semiconductor nanocrystal including a zinc selenide is about 3.2 nm.

Average values of circularity and roundness of the prepared semiconductor nanoparticle is about 0.87 and 0.91, respectively.

Comparative Preparation Example 1

The semiconductor nanoparticle is prepared in the same manner as set forth in Preparation Example 1, except that the reaction temperature is changed to 320 °C, the same amount of the aliquot is injected during the split injection of the selenium precursor, the intermediate separation is omitted, and the additive is not used.

An ICP-AES of the obtained semiconductor nanoparticles is analyzed, and the result data is listed in Table 1. A TEM analysis and a photoluminescent analysis are carried out and the results are shown in Table 2.

Average values of circularity and roundness of the prepared semiconductor nanoparticle is about 0.85 and 0.88, respectively.

Preparation Example 3

The semiconductor nanoparticle is prepared in the same manner as set forth in Preparation Example 1, except that the amount of the selenium precursor is increased by 50%, the reaction time for forming the zinc selenide semiconductor nanocrystal is also increased by 10 minutes, and the intermediate separation is omitted.

An ICP-AES of the obtained semiconductor nanoparticles is analyzed, and the result data is listed in Table 1. A TEM analysis, a UV-Vis absorption spectroscopy analysis, and a photoluminescent analysis are carried out and the results are shown in Table 2 and Table 3.

In the prepared semiconductor nanoparticle, a thickness of the semiconductor nanocrystal including a zinc selenide is about 3.3 nm.

Average values of circularity and roundness of the prepared semiconductor nanoparticle is about 0.84 and 0.88, respectively.

Comparative Preparation Example 2

The semiconductor nanoparticle is prepared in the same manner as set forth in Preparation Example 1, except that the additive is not used, the amount of the selenium precursor is injected simultaneously, and the intermediate separation is omitted.

An ICP-AES of the obtained semiconductor nanoparticles is analyzed, and the result data is listed in Table 1. In the prepared semiconductor nanoparticle, a thickness of the semiconductor nanocrystal including a zinc selenide is about 2 nm. An average particle size of the prepared semiconductor nanoparticle is about 6.7 nm as determined by a TEM analysis of the prepared semiconductor nanoparticle. A photoluminescent spectroscopy analysis is conducted and the photoluminescent peak wavelength is 532 nm.

Comparative Preparation Example 3

The semiconductor nanoparticle is prepared in the same manner as set forth in Preparation Example 2, except that the additive is not used, and the intermediate separation is omitted.

An ICP-AES of the obtained semiconductor nanoparticles is analyzed. The results confirm that a mole ratio of sulfur to selenium (S:Se) is 0.531:1, a mole ratio of selenium to indium (Se:In) is 39.4:1, a mole ratio of indium to a sum of sulfur and selenium [In : (S+Se)] is about 0.0166. In the obtained semiconductor nanoparticles, a mole ratio of zinc to indium (Zn:In) is below about 60:1. In the prepared semiconductor nanoparticle, a thickness of the semiconductor nanocrystal including a zinc selenide is about 2.4 nm. An average particle size of the prepared semiconductor nanoparticle is about 7.9 nm as determined by a TEM analysis of the prepared semiconductor nanoparticle. A photoluminescent spectroscopy analysis is conducted and the photoluminescent peak wavelength is 536 nm.

Comparative Preparation Example 4

The semiconductor nanoparticle is prepared in the same manner as set forth in Preparation Example 2, except that the additive is not used.

A photoluminescent spectroscopy analysis is conducted and the photoluminescent peak wavelength is 536 nm and an absolute QY is about 64%.

Average values of circularity and roundness of the prepared semiconductor nanoparticle is about 0.83 and 0.76, respectively.

Table 1

| Example | ICP mole ratio | | | | | |
|---|---|---|---|---|---|---|
| | S/Se | Zn/In | Se/In | In/In | In/(S+Se) | Zn/(S+Se) |
| Preparation Example 1 | 0.374 | 77.46 | 51.04 | 1 | 0.01426 | 1.10 |
| Preparation Example 2 | 0.266 | 102.0 | 72.9 | 1 | 0.01083 | 1.10 |
| Comparative Preparation Example 1 | 0.587 | 40.5 | 21.8 | 1 | 0.02890 | 1.17052 |
| Preparation Example 3 | 0.323 | 105.6 | 76.0 | 1 | 0.00994 | 1.05 |
| Comparative Preparation Example 2 | 0.447 | 42.9 | 24.9 | 1 | 0.02774 | 1.19 |

Table 2

| | PL wavelength (nm) | FWHM (nm) | absolute QY(%) | Particle size (average) | STD (percentage of the avg. particle size) |
|---|---|---|---|---|---|
| Preparation Example 1 | 545 | 41 | 99 | 8.1 nm | 5% |
| Preparation Example 2 | 537 | 40 | 94 | 9.4 nm | 5% |
| Comparative Preparation Example 1 | 539 | 36 | 90 | 7.1 nm | 16% |
| Preparation Example 3 | 539 | 39 | 90 | 9.7 nm | 7% |
| Comparative Preparation Example 4 | 537 | 38 | 64 | 10.3 nm | 7% |

In Table 2:

PL wavelength is a (maximum) photoluminescent peak wavelength,

FWHM is Full width at half maximum,

STD is standard deviation, and

QY is quantum yield

Table 3

| | 450 OD/1st peak | 1st peak wavelength (nm) | The lowest point of the valley (nm) | VD |
|---|---|---|---|---|
| Preparation Example 1 | 2.05 | 516 | 481 | 0.49 |
| Preparation Example 2 | 2.79 | 513 | 482 | 0.42 |
| Preparation Example 3 | 3.36 | 513 | 485 | 0.35 |

In Table 3,

VD is valley depth, and
450 OD/ 1st peak is a ratio of an absorbance at a wavelength of 450 nm to the absorbance at the first absorption peak.

The results of Table 2 confirm that the semiconductor nanoparticles of preparation Examples may exhibit improved luminous properties in comparison with the semiconductor nanoparticles of Comparative preparation Examples.
The results of Table 3 confirm that the semiconductor nanoparticles of preparation Examples may exhibit a relatively high level of the VD and a relatively increased absorption at a wavelength of about 450 nm.

Experimental Example 2

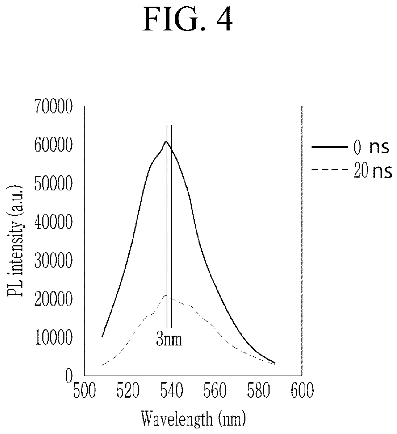

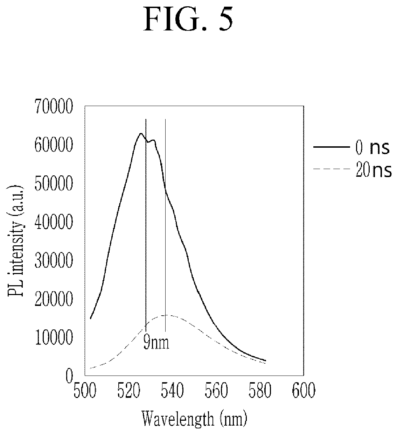

A DAS analysis is conducted for the semiconductor nanoparticles of preparation Examples 1 and 2, and the semiconductor nanoparticles of Comparative preparation Examples 2 and 3. The results are shown in Table 4. Also, the DAS analysis results for Preparation Example 1, and Comparative Preparation Example 2, are shown in FIG. 4 and FIG. 5, respectively.

Table 4

| Example | DAS wavelength difference |
|---|---|
| Comparative Preparation Example 2 | 9 nm |
| Comparative Preparation Example 3 | 6 nm |

(continued)

| Example | DAS wavelength difference |
| --- | --- |
| Preparation Example 1 | 3 nm |
| Preparation Example 2 | 3 nm |

The results of Table 4 confirm that the semiconductor nanoparticles of preparation Examples may exhibit a significantly suppressed fluorescence resonance energy transfer (FRET) in comparison with the semiconductor nanoparticles of Comparative preparation Examples.

Preparation of Electroluminescent Device

Device Example 1

The light-emitting device is fabricated using the plurality of semiconductor nanoparticles of preparation Example 1 according to the following method.

On an indium tin oxide (ITO) (anode)-deposited glass substrate, a poly(3,4-ethylenedioxythiophene)polystyrene sulfonate (PEDOT:PSS) solution (H.C. Starks) and poly[(9,9-dioctylfluorene-co-(4,4'-(N-4-butylphenyl)diphenylamine] solution (TFB) (Sumitomo) are spin-coated and then heat-treated as a hole injecting layer (HIL) and a hole transporting layer (HTL) with a thickness of 30 nm and a thickness of 25 nm, respectively.

The nanostructures obtained from Preparation Example 1 are dispersed in octane and is spin-coated on the HTL and heat-treated to provide a light-emitting film with a thickness of 25 nm.

On the light-emitting film, an electron transporting layer (ETL) including zinc oxide nanoparticles having a thickness of about 40 nm is formed by using $Zn_{1-x}Mg_xO$ nanoparticles according to Reference Example 2, and then an aluminum (Al) is vacuum-deposited on the ETL to provide a second electrode. It is confirmed that the obtained device emits green light by an application of a voltage. The electroluminescent properties of the obtained device are evaluated, and the results are shown in Table 5.

Device Example 2

A light-emitting device is fabricated in accordance with the same procedure as in Device Example 1, except for using the plurality of semiconductor nanoparticles of Preparation Example 2, instead of the nanostructures of Preparation Example 1 for the formation of the light-emitting film. It is confirmed that the obtained device emits green light having a maximum luminescent peak wavelength of about 540 nm by an application of a voltage. The electroluminescent properties of the obtained device are evaluated, and the results are shown in Table 5.

Device Example 3

A light-emitting device is fabricated in accordance with the same procedure as in Device Example 1, except for using the plurality of semiconductor nanoparticles of Preparation Example 3, instead of the nanostructures of Preparation Example 1 for the formation of the light-emitting film. It is confirmed that the obtained device emits green light by an application of a voltage. The electroluminescent properties of the obtained device are evaluated, and the results are shown in Table 5.

Comparative Device Example 1

A light-emitting device is fabricated in accordance with the same procedure as in Device Example 1, except for using the plurality of semiconductor nanoparticles of Comparative Preparation Example 1, instead of the nanostructures of Preparation Example 1 for the formation of the light-emitting film. It is confirmed that the obtained device emits green light by an application of a voltage. The electroluminescent properties of the obtained device are evaluated, and the results are shown in Table 5.

Comparative Device Example 2

A light-emitting device is fabricated in accordance with the same procedure as in Device Example 1, except for using the plurality of semiconductor nanoparticles of Comparative Preparation Example 2, instead of the nanostructures of Preparation Example 1 for the formation of the light-emitting film. It is confirmed that the obtained device emits green light by an application of a voltage. The electroluminescent properties of the obtained device are evaluated, and the results are shown in Table 5.

Comparative Device Example 3

A light-emitting device is fabricated in accordance with the same procedure as in Device Example 1, except for using the plurality of semiconductor nanoparticles of Comparative Preparation Example 3, instead of the nanostructures of Preparation Example 1 for the formation of the light-emitting film. It is confirmed that the obtained device emits green light a maximum luminescent peak wavelength of about 540 nm by an application of a voltage. The electroluminescent properties of the obtained device are evaluated, and the results are shown in Table 5.

Table 5

|  | Max. EQE (%) | Max. Luminance (nit) | T90 (hours) at 2700 nit |
|---|---|---|---|
| Device Example 1 | 10.2 | 484528 | 291.2 |
| Device Example 2 | 11 | 506646 | 624 |
| Device Example 3 | 11 | 485903 | 180 |
| Comp. Device Example 1 | 7 | 141600 | 8.6 |
| Comp. Device Example 2 | 7.9 | 263364 | 8.24 |
| Comp. Device Example 3 | 5.9 | 168041 | 5.8 |

In Table 5,

Max. EQE is maximum external quantum efficiency,
Max. Luminance is maximum luminance, and
nit is candelas per square meter ($cd/m^2$).

From the results of Table 5, it is confirmed that the devices according to Examples show, e.g., exhibit, improved electroluminescent properties together with increased lifespan properties, in comparison with the devices according to Comparative Examples.
While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

**Claims**

1. An electroluminescent device comprising:

a first electrode;
a second electrode; and
a light-emitting layer disposed between the first electrode and the second electrode, the light-emitting layer comprising a semiconductor nanoparticle having a core-shell structure including a core and a shell disposed on the core,
wherein the light-emitting layer is configured to emit green light,
wherein a maximum luminescent peak wavelength of the green light is greater than or equal to 490 nanometers and less than or equal to 580 nanometers,
wherein the semiconductor nanoparticle comprises a semiconductor nanocrystal comprising indium, phosphorus, zinc, selenium, and sulfur,
wherein the semiconductor nanocrystal comprises a first semiconductor nanocrystal comprising a Group III-V compound; and a second semiconductor nanocrystal comprising a zinc chalcogenide,
wherein in the core-shell structure, the core includes the first semiconductor nanocrystal and the shell includes the second semiconductor nanocrystal, and
wherein in the semiconductor nanoparticle, a mole ratio of zinc to indium is greater than or equal to 60:1 and less than or equal to 250:1.

2.  The electroluminescent device of claim 1, wherein the first semiconductor nanocrystal comprises indium, phosphorus, and optionally zinc;

    wherein the zinc chalcogenide comprises zinc, selenium, and sulfur, and
    wherein the light emitting layer does not include cadmium.

3.  The electroluminescent device of claims 1 or 2, wherein the electroluminescent device is configured to exhibit

    a T90 of greater than or equal to 120 hours as measured with an initial driving luminance of 2700 nit, or
    a T90 of greater than or equal to 500 hours as measured with an initial driving luminance of 1000 nit.

4.  The electroluminescent device of any of claims 1-3, wherein a particle size of the semiconductor nanoparticle is greater than or equal to 7.5 nanometers and less than or equal to 20 nanometers; and/or

    wherein a particle size of the plurality of the semiconductor nanoparticles is greater than or equal to 8 nanometers and less than or equal to 10 nm, optionally wherein the semiconductor nanoparticle exhibit a particle size distribution as a standard deviation that is less than or equal to 10 percent of an average size of the semiconductor nanoparticle, and/or
    wherein as determined in a transmission electron microscopy analysis of the semiconductor nanoparticle, the semiconductor nanoparticle shows an average particle size of greater than or equal to 7.5 nanometers and less than or equal to 20 nanometers; an average roundness of greater than or equal to 0.77; or both.

5.  The electroluminescent device of any of claims 2-4, wherein the shell comprises an inner layer comprising a zinc selenide, and an outer layer comprising a zinc sulfide, and the inner layer is between the core and the outer layer, and wherein a thickness of the inner layer is greater than or equal to 2.5 nanometers and less than or equal to 10 nanometers.

6.  The electroluminescent device of any of claims 1-5, wherein in the semiconductor nanoparticle, a mole ratio of zinc to indium is greater than or equal to 70:1 and less than or equal to 120:1, and a mole ratio of indium to a sum of selenium and sulfur is greater than or equal to 0.0001:1 and less than or equal to 0.03:1; and/or

    wherein in the semiconductor nanoparticle, a mole ratio of sulfur to selenium is less than or equal to 0.5:1; and/or
    wherein the semiconductor nanoparticle exhibits an absolute quantum yield of greater than or equal to 90 percent.

7.  The electroluminescent device of any of claims 1-6, wherein the semiconductor nanoparticle exhibits a wavelength difference of less than or equal to 5 nanometers in a Decay Associated Spectrum analysis, or

    wherein in an Ultraviolet-Visible absorption spectrum of the semiconductor nanoparticle, a valley depth, defined by the following equation, is greater than or equal to 0.35:

    $$(Abs_{first} - Abs_{valley})/ Abs_{first} = VD$$

    wherein $Abs_{first}$ is an absorbance at a wavelength of a first absorption peak, $Abs_{valley}$ is an absorbance at a lowest point of a valley adjacent to the first absorption peak, and VD is the valley depth.

8.  The electroluminescent device of any of claims 1-7, wherein the electroluminescent device exhibits a maximum external quantum efficiency of greater than or equal to 10 percent, or
    wherein the electroluminescent device exhibits a maximum luminance of greater than or equal to 300,000 candelas per square meter.

9.  Semiconductor nanoparticles comprising:

    a semiconductor nanocrystal having a core-shell structure including a core and a shell disposed on the core and comprising indium, phosphorus, zinc, selenium, and sulfur,
    wherein in the semiconductor nanoparticles,
    a mole ratio of zinc to indium is greater than or equal to 60:1 and less than or equal to 250:1,
    a mole ratio of indium to a sum of selenium and sulfur is greater than or equal to 0.0005:1 and less than or equal to 0.03:1,
wherein the semiconductor nanoparticles have a maximum luminescent peak wavelength in a range of greater than or equal to 490 nanometers and less than or equal to 580 nanometers,
wherein the semiconductor nanoparticles are configured to exhibit an absolute quantum yield of greater than or equal to 65 percent and less than or equal to 100%;
wherein the semiconductor nanocrystal comprises a first semiconductor nanocrystal comprising a Group III-V compound; and a second semiconductor nanocrystal comprising a zinc chalcogenide, and wherein the zinc chalcogenide comprises zinc, selenium, and sulfur, and the Group III-V compound comprises indium, phosphorus, and optionally zinc, and
wherein in the core-shell structure, the core includes the first semiconductor nanocrystal and the shell includes the second semiconductor nanocrystal;
preferably wherein the semiconductor nanoparticles do not comprise cadmium.

10. The semiconductor nanoparticles of claim 9,

wherein the semiconductor nanoparticles are configured to exhibit an absolute quantum yield of greater than or equal to 90 percent; or
wherein in an Ultraviolet-Visible absorption spectrum of the semiconductor nanoparticles, a valley depth defined by the following equation is greater than or equal to 0.35:

$$(Abs_{first} - Abs_{valley})/ Abs_{first} = VD$$

wherein $Abs_{first}$ is an absorbance at a wavelength of a first absorption peak, $Abs_{valley}$ is an absorbance at a lowest point of a valley adjacent to the first absorption peak, and VD is the valley depth; or
wherein in the Ultraviolet-Visible absorption spectrum of the semiconductor nanoparticles, a ratio of an absorbance at a wavelength of 450 nanometers to the absorbance at the first absorption peak is greater than or equal to 2:1; or
wherein the semiconductor nanoparticles exhibit a wavelength difference of less than or equal to 5 nanometers in a Decay Associated Spectrum analysis.

11. The semiconductor nanoparticles of claims 9 or 10, wherein as determined in a transmission electron microscopy analysis of the semiconductor nanoparticles,
the semiconductor nanoparticles show an average particle size of greater than or equal to 7.5 nanometers and less than or equal to 20 nanometers; an average roundness of greater than or equal to 0.77; or both.

12. The semiconductor nanoparticles of any of claims 9-11, wherein the shell comprises an inner layer comprising a zinc selenide, and an outer layer comprising a zinc sulfide, and the inner layer is disposed between the core and the outer layer, and
wherein a thickness of the inner layer is greater than or equal to 2.5 nanometers and less than or equal to 10 nanometers.

13. The semiconductor nanoparticles of any of claims 9-12, wherein the semiconductor nanoparticles comprise a mole ratio of sulfur to selenium that is less than or equal to 0.5:1, and optionally a mole ratio of selenium to indium that is greater than or equal to 51:1.

14. A display device including an electroluminescent device of any of claims 1-8 or the semiconductor nanoparticles of any of claims 9-13.

15. A method of producing the semiconductor nanoparticles of any of claims 9-13, the method comprising:

mixing a zinc precursor, a chalcogen precursor, an organic ligand, and a particle comprising a first semiconductor nanocrystal comprising indium, phosphorus, and optionally zinc in an organic solvent; and
conducting a reaction between the zinc precursor and the chalcogen precursor at a temperature of greater than 320 °C in the presence of the organic ligand and the particle comprising the first semiconductor nanocrystal in the organic solvent to form a second semiconductor nanocrystal comprising a zinc chalcogenide,
wherein the chalcogen precursor comprises a selenium precursor and a sulfur precursor,
wherein in the method, a reaction between the selenium precursor and the zinc precursor is carried out in the presence of an additive, and
wherein the additive comprises a sulfur compound different from the sulfur precursor, a C1 to C30 carboxylic acid gallium salt, an alkylated gallium, an alkali metal compound, a zinc halide, a lithium trialkyl borohydride, or a combination thereof, and
wherein an amount of the zinc precursor is greater than or equal to 60 moles per one mole of indium,
optionally wherein during the formation of the second semiconductor nanocrystal, the method further comprises performing an intermediate separation, and the intermediate separation comprises removing a formed particle, washing the removed particle, and adding the washed particle into a reaction system for forming the second semiconductor nanocrystal again.

**Patentansprüche**

1.  Elektrolumineszenzvorrichtung, umfassend:

    eine erste Elektrode;
    eine zweite Elektrode; und
    eine lichtemittierende Schicht, die zwischen der ersten Elektrode und der zweiten Elektrode angeordnet ist,
    wobei die lichtemittierende Schicht ein Halbleiternanopartikel umfasst, das eine Kern-Hülle-Struktur aufweist, die einen Kern und eine Hülle beinhaltet, die auf dem Kern angeordnet ist,
    wobei die lichtemittierende Schicht dazu konfiguriert ist, grünes Licht zu emittieren,
    wobei eine maximale Lumineszenzspitzenwellenlänge des grünen Lichts größer als oder gleich 490 Nanometer und weniger als oder gleich 580 Nanometer ist,
    wobei das Halbleiternanopartikel einen Halbleiternanokristall umfasst, der Indium, Phosphor, Zink, Selen und Schwefel umfasst,
    wobei der Halbleiternanokristall einen ersten Halbleiternanokristall, der eine Verbindung der Gruppe III-V umfasst; und einen zweiten Halbleiternanokristall, der ein Zinkchalkogenid umfasst, umfasst,
    wobei in der Kern-Hülle-Struktur der Kern den ersten Halbleiternanokristall beinhaltet und die Hülle den zweiten Halbleiternanokristall beinhaltet, und
    wobei in dem Halbleiternanopartikel ein Molverhältnis von Zink zu Indium größer als oder gleich 60:1 und weniger als oder gleich 250:1 ist.

2.  Elektrolumineszenzvorrichtung nach Anspruch 1, wobei der erste Halbleiternanokristall Indium, Phosphor und optional Zink umfasst;

    wobei das Zinkchalkogenid Zink, Selen und Schwefel umfasst, und
    wobei die lichtemittierende Schicht kein Cadmium beinhaltet.

3.  Elektrolumineszenzvorrichtung nach Anspruch 1 oder 2, wobei die Elektrolumineszenzvorrichtung dazu konfiguriert ist,

    eine T90 von größer als oder gleich 120 Stunden wie gemessen mit einer anfänglichen Antriebsleuchtdichte von 2700 Nit, oder
    eine T90 von größer als oder gleich 500 Stunden wie gemessen mit einer anfänglichen Antriebsleuchtdichte von 1000 Nit aufzuweisen.

4.  Elektrolumineszenzvorrichtung nach einem der Ansprüche 1-3, wobei eine Partikelgröße des Halbleiternanopartikels größer als oder gleich 7,5 Nanometer und weniger als oder gleich 20 Nanometer ist; und/oder

    wobei eine Partikelgröße der Vielzahl der Halbleiternanopartikel größer als oder gleich 8 Nanometer und weniger als oder gleich 10 nm ist, wobei optional das Halbleiternanopartikel eine Partikelgrößenverteilung als Standardabweichung aufweist, die weniger als oder gleich 10 Prozent einer durchschnittlichen Größe des Halbleiternanopartikels ist, und/oder
    wobei, wie in einer Transmissionselektronenmikroskopieanalyse des Halbleiternanopartikels bestimmt, das Halbleiternanopartikel eine durchschnittliche Partikelgröße von größer als oder gleich 7,5 Nanometer und weniger als oder gleich 20 Nanometer; eine durchschnittliche Rundheit von größer als oder gleich 0,77; oder beides zeigt.

5. Elektrolumineszenzvorrichtung nach einem der Ansprüche 2-4, wobei die Hülle eine innere Schicht, die ein Zinkselenid umfasst, und eine äußere Schicht, die ein Zinksulfid umfasst, umfasst und die innere Schicht zwischen dem Kern und der äußeren Schicht ist, und
wobei eine Dicke der inneren Schicht größer als oder gleich 2,5 Nanometer und weniger als oder gleich 10 Nanometer ist.

6. Elektrolumineszenzvorrichtung nach einem der Ansprüche 1-5, wobei in dem Halbleiternanopartikel ein Molverhältnis von Zink zu Indium größer als oder gleich 70:1 und weniger als oder gleich 120:1 ist und ein Molverhältnis von Indium zu einer Summe von Selen und Schwefel größer als oder gleich 0,0001:1 und weniger als oder gleich 0,03:1 ist; und/oder

wobei in dem Halbleiternanopartikel ein Molverhältnis von Schwefel zu Selen weniger als oder gleich 0,5:1 ist; und/oder
wobei das Halbleiternanopartikel eine absolute Quantenausbeute von größer als oder gleich 90 Prozent aufweist.

7. Elektrolumineszenzvorrichtung nach einem der Ansprüche 1-6, wobei das Halbleiternanopartikel einen Wellenlängenunterschied von weniger als oder gleich 5 Nanometer bei einer zerfallsassoziierten Spektralanalyse aufweist, oder

wobei in einem Ultraviolett-sichtbaren Absorptionsspektrum des Halbleiternanopartikels eine Taltiefe, definiert durch die folgende Gleichung, größer als oder gleich 0,35 ist:

$$(Ab_{Sfirst} - Ab_{Svalley})/Ab_{Sfirst} = VD$$

wobei $Ab_{Sfirst}$ ein Absorptionsvermögen bei einer Wellenlänge einer ersten Absorptionsspitze ist, $Ab_{Svalley}$ ein Absorptionsvermögen an einem tiefsten Punkt eines Tals benachbart zu der ersten Absorptionsspitze ist und VD die Taltiefe ist.

8. Elektrolumineszenzvorrichtung nach einem der Ansprüche 1-7, wobei die Elektrolumineszenzvorrichtung eine maximale externe Quanteneffizienz von größer als oder gleich 10 Prozent aufweist, oder
wobei die Elektrolumineszenzvorrichtung eine maximale Leuchtdichte von größer als oder gleich 300.000 Candelas pro Quadratmeter aufweist.

9. Halbleiternanopartikel, umfassend:

einen Halbleiternanokristall mit einer Kern-Hülle-Struktur, die einen Kern und eine Hülle beinhaltet, die auf dem Kern angeordnet ist und Indium, Phosphor, Zink, Selen und Schwefel umfasst,
wobei in den Halbleiternanopartikeln
ein Molverhältnis von Zink zu Indium größer als oder gleich 60:1 und weniger als oder gleich 250:1 ist,
ein Molverhältnis von Indium zu einer Summe von Selen und Schwefel größer als oder gleich 0,0005:1 und weniger als oder gleich 0,03:1 ist,
wobei die Halbleiternanopartikel eine maximale Lumineszenzspitzenwellenlänge in einem Bereich von größer als oder gleich 490 Nanometer und weniger als oder gleich 580 Nanometer aufweisen,
wobei die Halbleiternanopartikel dazu konfiguriert sind, eine absolute Quantenausbeute von größer als oder gleich 65 Prozent und weniger als oder gleich 100 % aufzuweisen;
wobei der Halbleiternanokristall einen ersten Halbleiternanokristall, der eine Verbindung der Gruppe III-V umfasst; und einen zweiten Halbleiternanokristall, der ein Zinkchalkogenid umfasst, umfasst, und wobei das Zinkchalkogenid Zink, Selen und Schwefel umfasst und die Verbindung der Gruppe III-V Indium, Phosphor und optional Zink umfasst, und
wobei in der Kern-Hülle-Struktur der Kern den ersten Halbleiternanokristall beinhaltet und die Hülle den zweiten Halbleiternanokristall beinhaltet;
wobei bevorzugt die Halbleiternanopartikel kein Cadmium umfassen.

10. Halbleiternanopartikel nach Anspruch 9,

wobei die Halbleiternanopartikel dazu konfiguriert sind, eine absolute Quantenausbeute von größer als oder gleich 90 Prozent aufzuweisen; oder

wobei in einem Ultraviolett-sichtbaren Absorptionsspektrum des Halbleiternanopartikels eine Taltiefe definiert durch die folgende Gleichung größer als oder gleich 0,35 ist:

$$(Ab_{Sfirst} - Ab_{Svalley})/Ab_{Sfirst} = VD$$

wobei $Ab_{Sfirst}$ ein Absorptionsvermögen bei einer Wellenlänge einer ersten Absorptionsspitze ist, $Ab_{Svalley}$ ein Absorptionsvermögen an einem tiefsten Punkt eines Tals benachbart zu der ersten Absorptionsspitze ist und VD die Taltiefe ist; oder

wobei in dem Ultraviolett-sichtbaren Absorptionsspektrum der Halbleiternanopartikel ein Verhältnis eines Absorptionsvermögens bei einer Wellenlänge von 450 Nanometer zu dem Absorptionsvermögen an der ersten Absorptionsspitze größer als oder gleich 2:1 ist; oder

wobei die Halbleiternanopartikel einen Wellenlängenunterschied von weniger als oder gleich 5 Nanometer bei einer zerfallsassoziierten Spektralanalyse aufweisen.

11. Halbleiternanopartikel nach Anspruch 9 oder 10, wobei, wie in einer Transmissionselektronenmikroskopieanalyse der Halbleiternanopartikel bestimmt,

die Halbleiternanopartikel eine durchschnittliche Partikelgröße von größer als oder gleich 7,5 Nanometer und weniger als oder gleich 20 Nanometer; eine durchschnittliche Rundheit von größer als oder gleich 0,77; oder beides zeigen.

12. Halbleiternanopartikel nach einem der Ansprüche 9-11, wobei die Hülle eine innere Schicht, die ein Zinkselenid umfasst, und eine äußere Schicht, die ein Zinksulfid umfasst, umfasst und die innere Schicht zwischen dem Kern und der äußeren Schicht angeordnet ist, und

wobei eine Dicke der inneren Schicht größer als oder gleich 2,5 Nanometer und weniger als oder gleich 10 Nanometer ist.

13. Halbleiternanopartikel nach einem der Ansprüche 9-12, wobei die Halbleiternanopartikel ein Molverhältnis von Schwefel zu Selen, das weniger als oder gleich 0,5:1 ist, und optional ein Molverhältnis von Selen zu Indium, das größer als oder gleich 51:1 ist, umfassen.

14. Anzeigevorrichtung, beinhaltend eine Elektrolumineszenzvorrichtung nach einem der Ansprüche 1-8 oder die Halbleiternanopartikel nach einem der Ansprüche 9-13.

15. Verfahren zum Herstellen der Halbleiternanopartikel nach einem der Ansprüche 9-13, wobei das Verfahren Folgendes umfasst:

Mischen eines Zinkvorläufers, eines Chalkogenvorläufers, eines organischen Liganden und eines Partikels, das einen ersten Halbleiternanokristall umfasst, der Indium, Phosphor und optional Zink umfasst, in einem organischen Lösungsmittel; und

Ausführen einer Reaktion zwischen dem Zinkvorläufer und dem Chalkogenvorläufer bei einer Temperatur von größer als 320 °C in der Gegenwart des organischen Liganden und des Partikels, das den ersten Halbleiternanokristall in dem organischen Lösungsmittel umfasst, um einen zweiten Halbleiternanokristall zu bilden, der ein Zinkchalkogenid umfasst,

wobei der Chalkogenvorläufer einen Selenvorläufer und einen Schwefelvorläufer umfasst,

wobei in dem Verfahren eine Reaktion zwischen dem Selenvorläufer und dem Zinkvorläufer in der Gegenwart eines Additivs durchgeführt wird, und

wobei das Additiv eine Schwefelverbindung, die sich von dem Schwefelvorläufer unterscheidet, ein C1- bis C30-Carbonsäuregalliumsalz, ein alkyliertes Gallium, eine Alkalimetallverbindung, ein Zinkhalogenid, ein Lithiumtrialkylborhydrid oder eine Kombination davon umfasst, und

wobei eine Menge des Zinkvorläufers größer als oder gleich 60 Mol pro ein Mol Indium ist,

wobei optional während der Bildung des zweiten Halbleiternanokristalls das Verfahren ferner Durchführen einer Zwischentrennung umfasst und die Zwischentrennung Entfernen eines gebildeten Partikels, Waschen des entfernten Partikels und Hinzufügen des gewaschenen Partikels in ein Reaktionssystem zum erneuten Bilden des zweiten Halbleiternanokristalls umfasst.

**Revendications**

1. Dispositif électroluminescent comprenant :

   une première électrode ;
   une seconde électrode ; et
   une couche électroluminescente disposée entre la première électrode et la seconde électrode, la couche électroluminescente comprenant une nanoparticule semi-conductrice comportant une structure noyau-enveloppe comprenant un noyau et une enveloppe disposée sur le noyau,
   dans lequel la couche électroluminescente est conçue pour émettre de la lumière verte,
   dans lequel une longueur d'onde maximale de pic luminescent de la lumière verte est supérieure ou égale à 490 nanomètres et inférieure ou égale à 580 nanomètres,
   dans lequel la nanoparticule semi-conductrice comprend un nanocristal semi-conducteur comprenant de l'indium, du phosphore, du zinc, du sélénium et du soufre,
   dans lequel le nanocristal semi-conducteur comprend un premier nanocristal semi-conducteur comprenant un composé du groupe III-V ; et un second nanocristal semi-conducteur comprenant un chalcogénure de zinc,
   dans lequel, dans la structure noyau-enveloppe, le noyau comprend le premier nanocristal semi-conducteur et l'enveloppe comprend le second nanocristal semi-conducteur, et
   dans lequel, dans la nanoparticule semi-conductrice, un rapport molaire entre le zinc et l'indium est supérieur ou égal à 60:1 et inférieur ou égal à 250:1.

2. Dispositif électroluminescent de la revendication 1, dans lequel le premier nanocristal semi-conducteur comprend de l'indium, du phosphore et éventuellement du zinc ;

   dans lequel le chalcogénure de zinc comprend du zinc, du sélénium et du soufre, et
   dans lequel la couche électroluminescente ne comprend pas de cadmium.

3. Dispositif électroluminescent des revendications 1 ou 2, dans lequel le dispositif électroluminescent est conçu pour présenter

   un T90 supérieur ou égal à 120 heures tel que mesuré avec une luminance de conduite initiale de 2 700 nits, ou
   un T90 supérieur ou égal à 500 heures tel que mesuré avec une luminance de conduite initiale de 1 000 nits.

4. Dispositif électroluminescent de l'une quelconque des revendications 1 à 3, dans lequel une taille de particule de la nanoparticule semi-conductrice est supérieure ou égale à 7,5 nanomètres et inférieure ou égale à 20 nanomètres ; et/ou

   dans lequel une taille de particule de la pluralité des nanoparticules semi-conductrices est supérieure ou égale à 8 nanomètres et inférieure ou égale à 10 nm, éventuellement dans lequel la nanoparticule semi-conductrice présente une distribution de taille de particule en tant qu'écart type qui est inférieure ou égale à 10 pour cent d'une taille moyenne de la nanoparticule semi-conductrice, et/ou
   dans lequel, comme déterminé dans une analyse par microscopie électronique à transmission de la nanoparticule semi-conductrice,
   la nanoparticule semi-conductrice montre une taille moyenne de particule supérieure ou égale à 7,5 nanomètres et inférieure ou égale à 20 nanomètres ; une rotondité moyenne supérieure ou égale à 0,77 ; ou les deux.

5. Dispositif électroluminescent de l'une quelconque des revendications 2 à 4, dans lequel la coque comprend une couche interne comprenant un séléniure de zinc, et une couche extérieure comprenant un sulfure de zinc, et la couche interne est entre le noyau et la couche extérieure, et
   dans lequel une épaisseur de la couche interne est supérieure ou égale à 2,5 nanomètres et inférieure ou égale à 10 nanomètres.

6. Dispositif électroluminescent de l'une quelconque des revendications 1 à 5, dans lequel, dans la nanoparticule semi-conductrice, un rapport molaire entre le zinc et l'indium est supérieur ou égal à 70:1 et inférieur ou égal à 120:1, et un rapport molaire entre l'indium et une somme du sélénium et du soufre est supérieur ou égal à 0,0001:1 et inférieur ou égal à 0,03:1 ; et/ou

   dans lequel, dans la nanoparticule semi-conductrice, un rapport molaire entre le soufre et le sélénium est inférieur ou égal à 0,5:1 ; et/ou
dans lequel la nanoparticule semi-conductrice présente un rendement quantique absolu supérieur ou égal à 90 pour cent.

7.  Dispositif électroluminescent de l'une quelconque des revendications 1 à 6, dans lequel la nanoparticule semi-conductrice présente une différence de longueur d'onde inférieure ou égale à 5 nanomètres dans une analyse de spectre associé à la désintégration, ou

dans lequel, dans un spectre d'absorption ultraviolet-visible de la nanoparticule semi-conductrice, une profondeur de vallée, définie par l'équation suivante, est supérieure ou égale à 0,35 :

$$(Ab_{Spremier} - Ab_{Svallée})/Ab_{Spremier} = PV$$

dans lequel $Ab_{Spremier}$ est une absorbance à une longueur d'onde d'un premier pic d'absorption, $Ab_{Svallée}$ est une absorbance à un point le plus bas de la vallée adjacent au premier pic d'absorption, et PV est la profondeur de la vallée.

8.  Dispositif électroluminescent de l'une quelconque des revendications 1 à 7, dans lequel le dispositif électroluminescent présente une efficacité quantique externe maximale supérieure ou égale à 10 pour cent, ou
dans lequel le dispositif électroluminescent présente une luminance maximale supérieure ou égale à 300 000 candelas par mètre carré.

9.  Nanoparticules semi-conductrices comprenant :

un nanocristal semi-conducteur comportant une structure noyau-enveloppe comprenant un noyau et une enveloppe disposée sur le noyau et comprenant de l'indium, du phosphore, du zinc, du sélénium et du soufre, dans lesquelles, dans les nanoparticules semi-conductrices,
un rapport molaire entre le zinc et l'indium est supérieur ou égal à 60:1 et inférieur ou égal à 250:1,
un rapport molaire entre l'indium et une somme du sélénium et du soufre est supérieur ou égal à 0,0005:1 et inférieur ou égal à 0,03:1,
dans lesquelles les nanoparticules semi-conductrices comportent une longueur d'onde maximale de pic luminescent dans une plage supérieure ou égale à 490 nanomètres et inférieure ou égale à 580 nanomètres, dans lesquelles les nanoparticules semi-conductrices sont conçues pour présenter un rendement quantique absolu supérieur ou égal à 65 pour cent et inférieur ou égal à 100 % ;
dans lesquelles le nanocristal semi-conducteur comprend un premier nanocristal semi-conducteur comprenant un composé du groupe III-V ; et un second nanocristal semi-conducteur comprenant un chalcogénure de zinc, et dans lesquelles le chalcogénure de zinc comprend du zinc, du sélénium et du soufre, et le composé du groupe III-V comprend de l'indium, du phosphore et éventuellement du zinc, et
dans lesquelles, dans la structure noyau-enveloppe, le noyau comprend le premier nanocristal semi-conducteur et l'enveloppe comprend le second nanocristal semi-conducteur ;
de préférence, dans lesquelles les nanoparticules semi-conductrices ne comprennent pas de cadmium.

10. Nanoparticules semi-conductrices de la revendication 9,

dans lesquelles les nanoparticules semi-conductrices sont conçues pour présenter un rendement quantique absolu supérieur ou égal à 90 pour cent ; ou
dans lesquelles, dans un spectre d'absorption ultraviolet-visible de la nanoparticule semi-conductrice, une profondeur de vallée définie par l'équation suivante est supérieure ou égale à 0,35 :

$$(Ab_{Spremier} - Ab_{Svallée})/Ab_{Spremier} = PV$$

dans lesquelles $Ab_{Spremier}$ est une absorbance à une longueur d'onde d'un premier pic d'absorption, $Ab_{Svallée}$ est une absorbance à un point le plus bas de la vallée adjacent au premier pic d'absorption, et PV est la profondeur de la vallée ; ou
dans lesquelles, dans le spectre d'absorption ultraviolet-visible des nanoparticules semi-conductrices, un rapport entre une absorbance à une longueur d'onde de 450 nanomètres et l'absorbance au premier pic d'absorption est supérieur ou égal à 2:1 ; ou

dans lesquelles les nanoparticules semi-conductrices présentent une différence de longeur d'onde inférieure ou égale à 5 nanomètres dans une analyse de spectre associé à la désintégration.

11. Nanoparticules semi-conductrices de la revendication 9 ou 10, dans lesquelles, comme déterminé dans une analyse par microscopie électronique à transmission des nanoparticules semi-conductrices, les nanoparticules semi-conductrices montrent une taille moyenne de particule supérieure ou égale à 7,5 nanomètres et inférieure ou égale à 20 nanomètres ; une rotondité moyenne supérieure ou égale à 0,77 ; ou les deux.

12. Nanoparticules semi-conductrices de l'une quelconque des revendications 9 à 11, dans lesquelles la coque comprend une couche interne comprenant un séléniure de zinc, et une couche extérieure comprenant un sulfure de zinc, et la couche interne est disposée entre le noyau et la couche extérieure, et dans lesquelles une épaisseur de la couche interne est supérieure ou égale à 2,5 nanomètres et inférieure ou égale à 10 nanomètres.

13. Nanoparticules semi-conductrices de l'une quelconque des revendications 9 à 12, dans lesquelles les nanoparticules semi-conductrices comprennent un rapport molaire entre le soufre et le sélénium qui est inférieur ou égal à 0,5: 1, et éventuellement un rapport molaire entre le sélénium et l'indium qui est supérieur ou égal à 51:1.

14. Dispositif d'affichage comprenant un dispositif électroluminescent de l'une quelconque des revendications 1 à 8 ou les nanoparticules semi-conductrices de l'une quelconque des revendications 9 à 13.

15. Procédé de production des nanoparticules semi-conductrice de l'une quelconque des revendications 9 à 13, le procédé comprenant :

le mélange d'un précurseur de zinc, d'un précurseur de chalcogène, d'un ligand organique et d'une particule comprenant un premier nanocristal semi-conducteur comprenant de l'indium, du phosphore et éventuellement du zinc dans un solvant organique ; et
la conduite d'une réaction entre le précurseur de zinc et le précurseur de chalcogène à une température supérieure à 320 °C en présence du ligand organique et de la particule comprenant le premier nanocristal semi-conducteur dans le solvant organique pour former un second nanocristal semi-conducteur comprenant un chalcogénure de zinc,
dans lequel le précurseur de chalcogène comprend un précurseur de sélénium et un précurseur de soufre,
dans lequel, dans le procédé, une réaction entre le précurseur de sélénium et le précurseur de zinc est effectuée en présence d'un additif, et
dans lequel l'additif comprend un composé de soufre différent du précurseur de soufre, un sel de gallium d'acide carboxylique en C1 à C30, un gallium alkylé, un composé de métal alcalin, un halogénure de zinc, un borohydrure de trialkyle de lithium ou une combinaison de ceux-ci, et
dans lequel une quantité du précurseur de zinc est supérieure ou égale à 60 moles pour une mole d'indium, éventuellement dans lequel, pendant la formation du second nanocristal semi-conducteur, le procédé comprend en outre la réalisation d'une séparation intermédiaire, et la séparation intermédiaire comprend le retrait d'une particule formée, le lavage de la particule retirée, et l'ajout de la particule lavée dans un système de réaction pour former à nouveau le second nanocristal semi-conducteur.

# FIG. 1

# FIG. 2

# FIG. 3

# FIG. 4

# FIG. 5

# FIG. 6

FIG. 7A

FIG. 7B

# FIG. 7C

EP 4 219 653 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2020399536 A
- CN 112048300

- EP 3660124 A